# EUROPEAN PATENT APPLICATION

(11) **EP 4 185 078 A1**
(43) Date of publication of application: **24.05.2023**
(21) Application number: 21851265.5
(22) Date of filing: 23.07.2021
(51) Int. Cl.: H05K 1/11

(54) **CIRCUIT BOARD ASSEMBLY AND PROCESSING METHOD THEREFOR, AND ELECTRONIC DEVICE**

(30) Priority: 31.07.2020 CN 202010755337; 30.09.2020 CN 202011058389
(71) Applicant: Huawei Technologies Co., Ltd., Shenzhen, Guangdong 518129 (CN)
(72) Inventor: HAN, Jianhua, Shenzhen, Guangdong 518129 (CN); TIAN, Qingshan, Shenzhen, Guangdong 518129 (CN); GUO, Xueping, Shenzhen, Guangdong 518129 (CN)
(74) Representative: Maiwald GmbH
(86) International application number: PCT/CN2021/108187
(87) International publication number: WO 2022/022419

(57) **Abstract**

This application provides a circuit board assembly and a processing method thereof, and an electronic device. The circuit board assembly includes: a circuit board, where the circuit board includes a conducting layer, solder resist layer, the conducting layer includes an electrical connection line and a solder pad substrate, the solder resist layer covers the electrical connection line, the solder resist layer includes an opening, and the solder pad substrate is located in a cavity formed by the opening; and an electronic component or a circuit board carrier, where the electronic component is disposed on a side that is of the circuit board and that is away from the conducting layer, and the circuit board carrier is disposed against a side that is of the solder resist layer and that is away from the conducting layer. The processing method of the circuit board assembly includes: disposing the solder resist layer on the circuit board carrier; removing a part of the solder resist layer to form the opening; and disposing the electrical connection line and the solder pad substrate on the solder resist layer, where the solder pad substrate is located in the cavity formed by the opening, and the electrical connection line is located on the side that is of the solder resist layer and that is away from the circuit board carrier. A purpose of this application is to improve mechanical reliability of a circuit board assembly in a processing process.

## Description

This application claims priority to Chinese Patent Application No. 202010755337.9, filed with the China National Intellectual Property Administration on July 31, 2020 and entitled "SUBSTRATE, SUBSTRATE MANUFACTURING METHOD, AND ELECTRONIC DEVICE", which is incorporated herein by reference in its entirety.

This application claims priority to Chinese Patent Application No. 202011058389.7, filed with the China National Intellectual Property Administration on September 30, 2020 and entitled "CIRCUIT BOARD ASSEMBLY AND PROCESSING METHOD THEREOF, AND ELECTRONIC DEVICE", which is incorporated herein by reference in its entirety.

### TECHNICAL FIELD

This application pertains to the field of electronic devices, and more specifically, relates to a circuit board assembly and a processing method thereof, and an electronic device.

### BACKGROUND

As an electronic device needs to implement more functions, an increasing quantity of electronic components are disposed inside the electronic device. An overall size of the electronic device may be increased to accommodate the increasing quantity of electronic components. However, this cannot follow a trend of electronic devices to be lighter and more portable. In this case, improving an integration level of the electronic device can dispose a large quantity of electronic components in limited space.

Reducing thickness of a circuit board in the electronic device helps improve the integration level of the electronic device. However, this may cause mechanical reliability issues of a circuit board assembly in a processing process.

### SUMMARY

This application provides a circuit board assembly and a processing method thereof, and an electronic device, to improve mechanical reliability of a circuit board assembly in a processing process.

According to a first aspect, a circuit board assembly is provided, including:
a first circuit board, where the first circuit board includes a first conducting layer and a first solder resist layer, the first conducting layer includes a first electrical connection line and a first solder pad substrate, the first solder resist layer covers the first electrical connection line, the first solder resist layer includes an opening, and the first solder pad substrate is located in a cavity formed by the opening; and
a first electronic component, where the first electronic component is disposed on the first circuit board, and the first electronic component and the first solder resist layer are respectively located on two sides of the first circuit board.

In this application, it can be learned from a location relationship between the first electrical connection line, the first solder pad substrate, and the first solder resist layer that the first conducting layer may be obtained by processing based on the first solder resist layer. This helps hide an electrical connection line close to an outer side and prevent the electrical connection line from being exposed to air.

With reference to the first aspect, in some implementations of the first aspect, the first electrical connection line is connected to the first solder pad substrate, and the first electrical connection line and the first solder pad substrate are respectively located at locations with different heights in the first circuit board.

In this application, it can be learned from a location relationship between the first electrical connection line, the first solder pad substrate, and the first solder resist layer that the first conducting layer may be obtained by processing based on the first solder resist layer. This helps hide an electrical connection line close to an outer side and prevent the electrical connection line from being exposed to air. It can be learned from a common processing procedure of the circuit board assembly that this is also conducive to delaying separation of a circuit board carrier from the circuit board. Therefore, in a process of processing and packaging the circuit board assembly, the circuit board can always be supported by the circuit board carrier. This helps improve mechanical reliability of the circuit board assembly in a processing process, and reduce a limitation on thickness of the circuit board. In the process of processing and packaging the circuit board assembly, the same circuit board carrier is always used. This helps reduce processing complexity of the circuit board assembly.

With reference to the first aspect, in some implementations of the first aspect, a material of the first solder resist layer is a photo imageable dielectric (PID) material.

In this application, because the PID has features such as supporting direct exposure and development, compatibility with the SAP process, and serving as both a dielectric and a solder resist material, compact electrical connection lines can be obtained by using the PID on an insulation component such as a solder resist layer, and the electrical connection line close to the outer side can be hidden, to prevent the electrical connection line from being exposed to air. In addition, using the PID helps delay separation of the circuit board carrier from the circuit board (for example, the circuit board carrier is removed after the circuit board assembly is packaged). Therefore, in a process of processing and packaging the circuit board assembly, the circuit board can always be supported by the circuit board carrier. This helps improve mechanical reliability of the circuit board assembly in a processing process, and reduce a limitation on thickness of the circuit board. In addition, in the process of processing and packaging the circuit board assembly, the same circuit board carrier is always used. This helps reduce processing complexity of the circuit board assembly. In addition, because the PID and the electrical connection line are made of different materials, difficulty of AOI is reduced, or coverage of an AOI test is expanded.

With reference to the first aspect, in some implementations of the first aspect, the circuit board assembly includes a plurality of conducting layers and at least one insulation layer, one insulation layer is disposed between any two adjacent conducting layers, the plurality of conducting layers includes the first conducting layer, the at least one insulation layer includes a first insulation layer and/or a second insulation layer, a material of the first insulation layer is the PID, and a material of the second insulation layer is an ajinomoto build-up film (ABF) or an ABF-like material.

In this application, the PID, the ABF, or the ABF-like material is used, to help obtain electrical connection lines with high compactness.

With reference to the first aspect, in some implementations of the first aspect, a material of each of the at least one insulation layer is the PID, the ABF, or the ABF-like material.

In this application, the material of each insulation layer in the entire first circuit board is the PID, the ABF, or the ABF-like material, to help obtain compact electrical connection lines.

With reference to the first aspect, in some implementations of the first aspect, the first circuit board further includes a second solder resist layer, the second solder resist layer is located on a side that is of the first circuit board and that is away from the first solder resist layer, and a material of the second solder resist layer is the PID.

In this application, any cavity may be formed on all insulation materials of the entire first circuit board by using the PID. This helps form a blind hole or via of any shape in the entire first circuit board.

With reference to the first aspect, in some implementations of the first aspect, the first circuit board further includes a second conducting layer, the second conducting layer is disposed on a side that is of the first circuit board and that is away from the first conducting layer, the second conducting layer includes a second electrical connection line and a second solder pad substrate, the second electrical connection line is connected to the second solder pad substrate, and the second electrical connection line and the second solder pad substrate are located at locations with a same height in the second circuit board.

With reference to the first aspect, in some implementations of the first aspect, the first circuit board further includes a groove, and a bottom of the groove is disposed on any conducting layer of the first circuit board other than the second conducting layer.

The circuit board assembly further includes a second electronic component, and the second electronic component is accommodated in the groove and is fastened to the any conducting layer.

In this application, a cavity structure is formed on the first circuit board. This helps reduce an overall height of the circuit board assembly, and further helps improve assembly integration of the circuit board assembly.

With reference to the first aspect, in some implementations of the first aspect, the second electronic component further includes a second pin, the second pin is located on a side that is of the second electronic component and that is away from the first circuit board, and the circuit board assembly further includes a second electrical connection wire electrically connected between the second pin and the first circuit board.

In this application, the cavity structure is formed on the first circuit board, so that a length of an electrical connection wire extending out of the cavity is reduced, and further signal transmission quality of the electrical connection wire is improved.

With reference to the first aspect, in some implementations of the first aspect, the first circuit board further includes a first solder pad protective layer, and the first solder pad protective layer covers the first solder pad substrate.

With reference to the first aspect, in some implementations of the first aspect, the circuit board assembly further includes a solder, and the solder is disposed on the first solder pad protective layer.

With reference to the first aspect, in some implementations of the first aspect, the electronic component further includes a first pin and an electrical connection wire, the first pin is located on a side that is of the electronic component and that is away from the first circuit board, and the electrical connection wire is electrically connected between the first pin and the first circuit board.

With reference to the first aspect, in some implementations of the first aspect, the circuit board assembly further includes a packaging material, and the packaging material wraps the electronic component and touches the side that is of the first circuit board and that is away from the first conducting layer.

With reference to the first aspect, in some implementations of the first aspect, the circuit board assembly further includes a second circuit board, and the second circuit board is disposed on a side that is of the first circuit board and that is close to the first conducting layer.

With reference to the first aspect, in some implementations of the first aspect, the circuit board assembly further includes a third circuit board, the third circuit board is located on a side that is of the packaging material and that is away from the first conducting layer, the packaging material further includes an electrical connector that runs through the packaging material, and the electrical connector is electrically connected between the first circuit board and the third circuit board.

With reference to the first aspect, in some implementations of the first aspect, the circuit board assembly further includes a circuit board carrier, and the circuit board carrier is disposed against a side that is of the first solder resist layer and that is away from the first conducting layer.

In this application, after the electronic component is disposed on the first circuit board, the circuit board carrier is removed. Therefore, in a process of processing and packaging the circuit board assembly, the circuit board can always be supported by the circuit board carrier. This helps improve mechanical reliability of the circuit board assembly in a processing process, and reduce a limitation on thickness of the circuit board.

According to a second aspect, an electronic device is provided, including the circuit board assembly according to any implementation of the first aspect.

According to a third aspect, a circuit board assembly is provided. The circuit board assembly includes: a first circuit board, where the first circuit board includes a first conducting layer and a first solder resist layer, the first conducting layer includes a first electrical connection line and a first solder pad substrate, the first solder resist layer covers the first electrical connection line, the first solder resist layer includes an opening, and the first solder pad substrate is located in a cavity formed by the opening; and
a circuit board carrier, where the circuit board carrier is disposed against a side that is of the first solder resist layer and that is away from the first conducting layer.

In this application, after the electronic component is disposed on the first circuit board, the circuit board carrier is removed. Therefore, in a process of processing and packaging the circuit board assembly, the circuit board can always be supported by the circuit board carrier. This helps improve mechanical reliability of the circuit board assembly in a processing process, and reduce a limitation on thickness of the circuit board.

With reference to the third aspect, in some implementations of the third aspect, the first electrical connection line is connected to the first solder pad substrate, and the first electrical connection line and the first solder pad substrate are respectively located at locations with different heights in the first circuit board.

In this application, it can be learned from a location relationship between the first electrical connection line, the first solder pad substrate, and the first solder resist layer that the first conducting layer may be obtained by processing based on the first solder resist layer. This helps hide an electrical connection line close to an outer side and prevent the electrical connection line from being exposed to air.

With reference to the third aspect, in some implementations of the third aspect, a material of the first solder resist layer is a photo imageable dielectric (PID) material.

In this application, because the PID has features such as supporting direct exposure and development, compatibility with the SAP process, and serving as both a dielectric and a solder resist material, compact electrical connection lines can be obtained by using the PID on an insulation component such as a solder resist layer, and the electrical connection line close to the outer side can be hidden, to prevent the electrical connection line from being exposed to air. In addition, using the PID helps delay separation of the circuit board carrier from the circuit board (for example, the circuit board carrier is removed after the circuit board assembly is packaged). Therefore, in a process of processing and packaging the circuit board assembly, the circuit board can always be supported by the circuit board carrier. This helps improve mechanical reliability of the circuit board assembly in a processing process, and reduce a limitation on thickness of the circuit board. In addition, in the process of processing and packaging the circuit board assembly, the same circuit board carrier is always used. This helps reduce processing complexity of the circuit board assembly. In addition, because the PID and the electrical connection line are made of different materials, difficulty of AOI is reduced, or coverage of an AOI test is expanded.

With reference to the third aspect, in some implementations of the third aspect, the circuit board assembly includes a plurality of conducting layers and at least one insulation layer, one insulation layer is disposed between any two adjacent conducting layers, the plurality of conducting layers includes the first conducting layer, the at least one insulation layer includes a first insulation layer and/or a second insulation layer, a material of the first insulation layer is the PID, and a material of the second insulation layer is an ajinomoto build-up film (ABF) or an ABF-like material.

In this application, the PID, the ABF, or the ABF-like material is used, to help obtain electrical connection lines with high compactness.

With reference to the third aspect, in some implementations of the third aspect, a material of each of the at least one insulation layer is the PID, the ABF, or the ABF-like material.

In this application, the material of each insulation layer in the entire first circuit board is the PID, the ABF, or the ABF-like material, to help obtain compact electrical connection lines.

With reference to the third aspect, in some implementations of the third aspect, the first circuit board further includes a second solder resist layer, the second solder resist layer is located on a side that is of the first circuit board and that is away from the first solder resist layer, and a material of the second solder resist layer is the PID.

In this application, any cavity may be formed on all insulation materials of the entire first circuit board by using the PID. This helps form a blind hole or via of any shape in the entire first circuit board.

With reference to the third aspect, in some implementations of the third aspect, the first circuit board further includes a first solder pad protective layer, and the first solder pad protective layer covers the first solder pad substrate and is located between the first solder pad substrate and the circuit board carrier.

With reference to the third aspect, in some implementations of the third aspect, the first circuit board further includes a groove, and a bottom of the groove is disposed on any conducting layer of the first circuit board other than the second conducting layer.

The circuit board assembly further includes a second electronic component, and the second electronic component is accommodated in the groove and is fastened to the any conducting layer.

In this application, a cavity structure is formed on the first circuit board. This helps reduce an overall height of the circuit board assembly, and further helps improve assembly integration of the circuit board assembly.

With reference to the third aspect, in some implementations of the third aspect, the second electronic component further includes a second pin, the second pin is located on a side that is of the second electronic component and that is away from the first circuit board, and the circuit board assembly further includes a second electrical connection wire electrically connected between the second pin and the first circuit board.

In this application, the cavity structure is formed on the first circuit board, so that a length of an electrical connection wire extending out of the cavity is reduced, and further signal transmission quality of the electrical connection wire is improved.

According to a fourth aspect, a processing method of a circuit board assembly is provided, including:
disposing a first solder resist layer on a circuit board carrier;
removing a part of the first solder resist layer, to form an opening on the first solder resist layer;
disposing a first conducting layer on the first solder resist layer, where the first conducting layer includes a first electrical connection line and a first solder pad substrate, the first electrical connection line is connected to the first solder pad substrate, the first solder pad substrate is located in a cavity formed by the opening, and the first electrical connection line is located on a side that is of the first solder resist layer and that is away from the circuit board carrier;
disposing at least one insulation layer and at least one conducting layer in a spaced manner on the first conducting layer, where one insulation layer is disposed between any two adjacent conducting layers, and the at least one conducting layer includes a second conducting layer; and
disposing a second solder resist layer on the second conducting layer.

In this application, it can be learned from a location relationship between the first electrical connection line, the first solder pad substrate, and the first solder resist layer that the first conducting layer may be obtained by processing based on the first solder resist layer. This helps hide an electrical connection line close to an outer side and prevent the electrical connection line from being exposed to air. It can be learned from a common processing procedure of the circuit board assembly that this is also conducive to delaying separation of the circuit board carrier from a circuit board. Therefore, in a process of processing and packaging the circuit board assembly, the circuit board can always be supported by the circuit board carrier. This helps improve mechanical reliability of the circuit board assembly in a processing process, and reduce a limitation on thickness of the circuit board. In the process of processing and packaging the circuit board assembly, the same circuit board carrier is always used. This helps reduce processing complexity of the circuit board assembly.

With reference to the fourth aspect, in some implementations of the fourth aspect, the second conducting layer includes a second electrical connection line and a second solder pad substrate, the second solder resist layer covers the second electrical connection line, and the method further includes:
disposing a second solder pad protective layer on the second solder pad substrate to form a second solder pad.

With reference to the fourth aspect, in some implementations of the fourth aspect, the method further includes:
fastening an electronic component to the second solder pad.

With reference to the fourth aspect, in some implementations of the fourth aspect, the method further includes:
disposing a packaging material, where the packaging material wraps a periphery of the electronic component and touches the second solder resist layer.

With reference to the fourth aspect, in some implementations of the fourth aspect, the method further includes:
separating the circuit board carrier from the first solder resist layer.

With reference to the fourth aspect, in some implementations of the fourth aspect, the method further includes:
disposing a first solder pad protective layer on the first solder pad substrate.

With reference to the fourth aspect, in some implementations of the fourth aspect, the method further includes:
removing a part of an area of each of at least one target insulation layer of a first circuit board and a part of an area of the second solder resist layer, to form a groove, where a material of each target insulation layer is a PID, a material of the second solder resist layer is the PID, and the at least one target insulation layer includes all insulation layers located between a third conducting layer and the second conducting layer, the third conducting layer is any conducting layer located between the first conducting layer and the second conducting layer, the third conducting layer includes a third solder pad substrate, and a bottom of the groove corresponds to the third solder pad substrate;
disposing a third solder pad protective layer on the third solder pad substrate, to form a third solder pad;
fastening a second electronic component to the third solder pad; and
disposing a packaging material, where the packaging material wraps the second electronic component and touches the bottom of the groove.

In this application, any cavity may be formed on all insulation materials of the entire first circuit board by using the PID. This helps form a cavity structure in the entire first circuit board. The cavity structure helps reduce an overall height of the circuit board assembly, and further helps improve assembly integration of the circuit board assembly.

With reference to the fourth aspect, in some implementations of the fourth aspect, the method further includes:
after the second solder resist layer is disposed, removing a part of the area of the second solder resist layer, to form a first through hole that runs through the second solder resist layer, where the first through hole corresponds to the second solder pad of the first circuit board, and the second solder resist layer is the PID;
disposing a first electrical holder on the second solder pad, where the first electrical holder is flush with an opening that is of the first through hole and that is away from the second solder pad, or extends out of the first through hole;
disposing the packaging material, where the packaging material is the PID, and the packaging material touch the first electrical holder;
removing a part of an area of the packaging material to form a second through hole that runs through the packaging material, where the second through hole corresponds to the first electrical holder;
disposing an electrical connection coating on a hole wall of the second through hole; and
filling with a conductive material based on the electrical connection coating, to form a second electrical holder, where the second electrical holder is connected to the first electrical holder to form a second via.

In this application, any cavity may be formed on all insulation materials of the entire first circuit board by using the PID. This helps form a blind hole or via of any shape in the entire first circuit board.

### BRIEF DESCRIPTION OF DRAWINGS

FIG. 1 is a schematic diagram of a structure of an electronic device;
FIG. 2 is a schematic diagram of a structure of a circuit board assembly;
FIG. 3 is a schematic flowchart of a processing method of a circuit board assembly;
FIG. 4 is a schematic flowchart of another processing method of a circuit board assembly;
FIG. 5 is a schematic flowchart of still another processing method of a circuit board assembly;
FIG. 6 is a schematic diagram of a structure of a circuit board assembly according to an embodiment of this application;
FIG. 7 is a schematic diagram of comparison between circuit board assemblies according to an embodiment of this application;
FIG. 8 is a schematic flowchart of a processing method of a circuit board assembly according to an embodiment of this application;
FIG. 9 is a schematic diagram of a structure of a circuit board assembly according to an embodiment of this application;
FIG. 10 is a schematic diagram of a structure of a circuit board assembly according to an embodiment of this application;
FIG. 11 is a schematic diagram of a structure of a circuit board assembly according to an embodiment of this application;
FIG. 12 is a schematic diagram of a structure of a circuit board assembly according to an embodiment of this application;
FIG. 13 is a schematic diagram of a structure of a circuit board assembly according to an embodiment of this application;
FIG. 14 is a schematic diagram of a structure of a circuit board assembly according to an embodiment of this application;
FIG. 15 is a schematic diagram of a structure of a circuit board assembly according to an embodiment of this application;
FIG. 16 is a schematic diagram of a structure of a circuit board assembly according to an embodiment of this application;
FIG. 17 is a schematic structural diagram of an electrical connection relationship in a circuit board assembly according to an embodiment of this application;
FIG. 18 is a schematic diagram of a structure of a circuit board assembly according to an embodiment of this application;
FIG. 19 is a schematic diagram of a structure of a circuit board assembly according to an embodiment of this application; and
FIG. 20 is a schematic diagram of a structure of a circuit board assembly according to an embodiment of this application.

### DESCRIPTION OF EMBODIMENTS

The following describes technical solutions of this application with reference to the accompanying drawings.

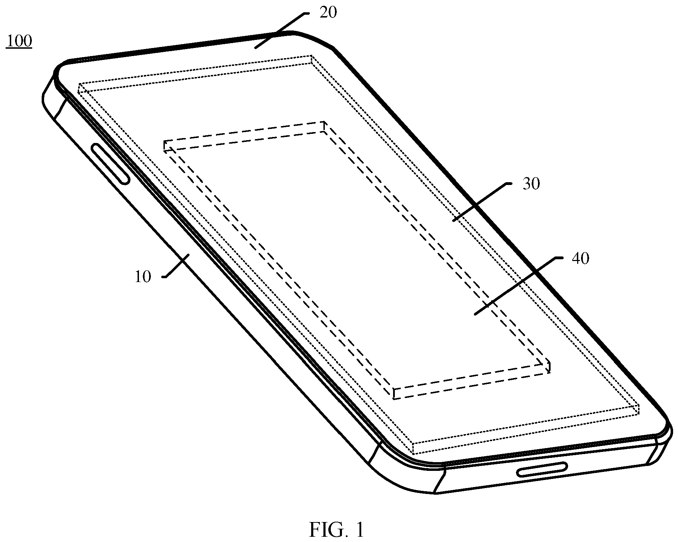

FIG. 1 is a schematic diagram of a structure of an electronic device 100 according to an embodiment of this application.

The electronic device 100 may be a device such as a mobile phone, a tablet computer, an electronic reader, a notebook computer, a digital camera, a vehicle-mounted device, or a wearable device. The electronic device 100 may alternatively be a base station, a car, an aviation instrument, a router, a smart speaker, an unmanned aerial vehicle, or the like. In the embodiment shown in FIG. 1, an example in which the electronic device 100 is a mobile phone is used for description.

The electronic device 100 includes a housing 10, a display 20, and a circuit board assembly 30. The display 20 and the circuit board assembly 30 may be installed on the housing 10. Specifically, the housing 10 may include a frame and a back cover. The frame surrounds a periphery of the display 20 and a periphery of the back cover. The display 20 and the back cover may be disposed in a spaced manner. A cavity formed by the display 20, the frame, and the back cover may be used to place the circuit board assembly 30. The electronic device 100 further includes a power supply 40 used to supply power to the circuit board assembly 30. The power supply 40 may be, for example, a lithium-ion battery.

The circuit board assembly 30 may include at least one circuit board and a plurality of electronic components electrically connected to any circuit board.

An electronic device has a feature and a development trend of being light, thin, short, and small. Components and modules inside the electronic device need to have features such as a high integration level, a thin stacking thickness, and a small unit size. The circuit board needs to have a board thickness as thin as possible, a cabling manner as compact as possible, and a via as small as possible.

A conventional core (core) circuit board is manufactured from a middle core board first. Because the middle core board has a specific thickness and is limited by a thin board capability of a device, currently, a board thickness of the core circuit board is usually greater than 40 µm.

A coreless (coreless) circuit board is a widely-used thin board technology. A thin-thickness circuit board can be obtained by manufacturing a conducting layer and an insulation layer through layer adding on a circuit board carrier (carrier). The circuit board carrier, as an intermediate carrier, is finally removed. A coreless circuit board technology usually relates to a circuit board carrier and an embedded trace substrate (embedded trace substrate, ETS) (for ease of description, the embedded trace substrate is referred to as an ETS circuit board for short below). Thin lines with high compactness may be designed on an embedded trace layer (embedded trace layer) of the ETS circuit board.

In this application, the circuit board may be a printed circuit board (printed circuit board, PCB), a flexible circuit board, an integrated circuit (or referred to as a chip), or the like. According to a quantity of electronic components borne on the circuit board, the circuit board may be a single-sided board or double-sided board. The single-sided board may refer to a circuit board that bears electronic components on a single side. The double-sided board may refer to a circuit board that bears electronic components on double sides. Based on types of electronic components borne on the circuit board, the circuit board may be a mainboard, a radio frequency (radio frequency, RF) board, an application processor (application processor, AP) board, or the like. The mainboard may be a main circuit board in the electronic device. The RF board can be used to bear a radio frequency integrated circuit (radio frequency integrated circuit, RF IC), a radio frequency power amplifier (radio frequency power amplifier, RF PA), and a wireless fidelity (wireless fidelity, Wi-Fi) chip. The AP board may be, for example, used to bear a system on chip (system on chip, SOC) component, a double data rate (double data rate, DDR) memory, a primary power management chip (power management unit, PMU), an auxiliary PMU, and the like.

An example is used for detailed description in which the circuit board is a PCB.

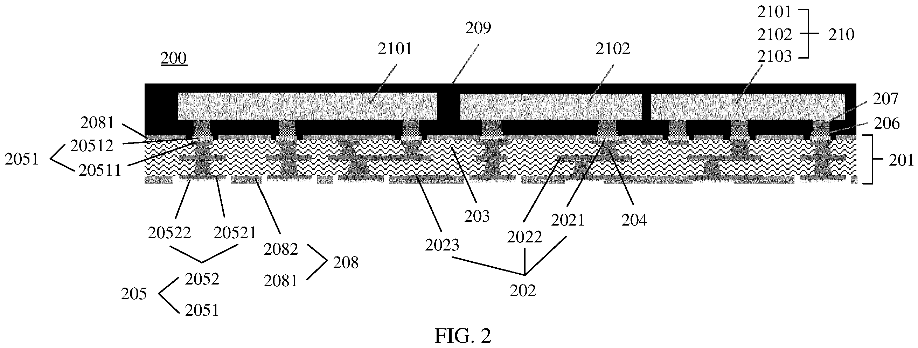

FIG. 2 is a schematic diagram of a structure of a circuit board assembly 200 according to some embodiments. The circuit board assembly 200 may be an example of the circuit board assembly 30 of the electronic device 100 shown in FIG. 1.

The circuit board assembly 200 may include a PCB 201 and at least one electronic component 210 electrically connected to the PCB. The power supply 40 in FIG. 1 may be used to supply power to the PCB 201 and/or the electronic component 210.

The PCB 201 may include a plurality of conducting layers 202 and at least one insulation layer 203 that are disposed in a spaced manner (the insulation layer 203 is shown in a wavy line pattern in FIG. 2). One insulation layer 203 is disposed between two adjacent conducting layers 202. When the PCB 201 includes a plurality of insulation layers 203, one conducting layer 202 is disposed between two adjacent insulation layers 203. The conducting layer 202 may include an electrical connection line (or a line for short, and may include at least one of the following: an ETS, a redistribution layer (redistribution layer, RDL), and the like). The insulation layer 203 may also be referred to as an interlayer medium. A material of the insulation layer may be, for example, a prepreg (prepreg, PP).

As shown in FIG. 2, the PCB 201 may include three conducting layers 202: a conducting layer 2021, a conducting layer 2022 and a conducting layer 2023. It should be understood that, a quantity of conducting layers 202 in the PCB 201 may not be limited in this application. In other words, based on embodiments provided in this application, a person skilled in the art may further think of another circuit board having fewer or more conducting layers 202.

The PCB 201 may further include a via 204, and the via 204 may be electrically connected between two conducting layers 202.

As shown in FIG. 2, the PCB 201 may include a via 204 disposed between the conducting layer 2021 and the conducting layer 2022. In other words, the via 204 can be used to implement an electrical connection between the conducting layer 2021 and the conducting layer 2022. It should be understood that, a quantity of vias 204 in the PCB 201 may not be limited in this application. In other words, based on embodiments provided in this application, a person skilled in the art may further think of another circuit board having fewer or more vias 204.

The PCB 201 may further include a solder pad 205, used to implement an electrical connection between the PCB 201 and another circuit board or the electronic component 210. The solder pad 205 may further include a solder pad substrate 2051 and a solder pad protective layer 2052.

As shown in FIG. 2, the PCB 201 may include a solder pad 2051 and a solder pad 2052. The solder pad 2051 may include a solder pad substrate 20511 and a solder pad protective layer 20512. The solder pad 2052 may include a solder pad substrate 20521 and a solder pad protective layer 20522. The solder pad substrate 20511 of the solder pad 2051 may be located on the conducting layer 2021, and the solder pad substrate 20521 of the solder pad 2052 may be located on the conducting layer 2023. The solder pad protective layer 20512 may be located on a side that is of the solder pad substrate 20511 and that is away from the PCB 201, and the solder pad protective layer 20512 can protect the solder pad substrate 20511, to avoid exposure of the solder pad substrate 20511 as much as possible. Similarly, the solder pad protective layer 20522 may be located on a side that is of the solder pad substrate 20521 and that is away from the PCB 201, and the solder pad protective layer 20522 can protect the solder pad substrate 20521, to avoid exposure of the solder pad substrate 20521 as much as possible.

As shown in FIG. 2, the electronic component 210 may be fastened to the PCB 201 by using the solder pad 2051, and is electrically connected to the PCB 201 by using the solder pad 2051. A circuit board or an electronic component 210 may not be disposed on the solder pad 2052 temporarily. It should be understood that FIG. 2 is merely an example. A circuit board or an electronic component 210 may alternatively be disposed on the solder pad 2052.

The circuit board assembly 200 may also include a solder 206 (the solder 206 is shown in a dot pattern in FIG. 2). The solder 206 may be used for a mechanical connection and/or an electrical connection. A shape of the solder 206 may be a spherical shape, a polyhedron shape, an ellipsoid shape, a truncated cone shape, a chamfer shape, a strip shape, a rod shape, or the like. The electronic component 210 may be fastened to the solder pad 205 of the PCB 201 by using the solder 206. As shown in FIG. 2, the electronic component 210 may be fastened to the solder pad 2051 by using the solder 206. Optionally, as shown in FIG. 2, the circuit board assembly 200 may further include an electrical holder 207, and the electrical holder 207 may be electrically connected between the electronic component 210 and the solder 206.

The PCB 201 may further include a solder resist (solder resist, SR) layer 208. The solder resist layer 208 is disposed on a side that is of the PCB 201 and that has the solder pad 205. In one aspect, the solder resist layer 208 may cover a part of the conducting layer 202 of the PCB 201, to protect an electrical connection line on the part of the conducting layer 202, and avoid exposure of the electrical connection line as much as possible. In another aspect, the solder resist layer 208 may limit flow of the solder 206, so that the solder 206 stays on the solder pad 205. The solder resist layer 208 may also be referred to as a surface medium.

As shown in FIG. 2, the PCB 201 may include a solder resist layer 2081 and a solder resist layer 2082. The solder resist layer 2081 and the solder resist layer 2082 may be respectively located on two sides of the PCB 201. The solder resist layer 2081 and the solder pad 2051 may be located on a same side of the PCB 201, so that the solder resist layer 2081 may cover a part of an electrical connection line on the conducting layer 2021. The solder resist layer 2082 and the solder pad 2052 may be located on a same side of the PCB 201, so that the solder resist layer 2082 may cover a part of an electrical connection line on the conducting layer 2023.

The circuit board assembly 200 may include at least one of the following electronic components 210: a connector, an electronic transformer, a relay, a laser component, a packaged component, a biometric feature identification module, a processor, a memory (such as a DDR memory), a power module, and the like. The electronic component 210 may further include, for example, a SOC component, a primary PMU, an RF IC, an RF PA, a Wi-Fi chip, a secondary PMU, and the like. The electronic component 210 may be a single electronic component 210, or may be obtained in a stacking manner. In an example, the SOC component may be stacked with the DDR memory to form a package on package (package on package, PoP) component. In another example, the SOC component and the DDR memory may be disposed separately.

FIG. 2 shows a solution in which the electronic component 210 is disposed on the circuit board assembly 200. The circuit board assembly 200 may include an electronic component 2101, an electronic component 2102, and an electronic component 2103. The circuit board assembly 200 may further include a packaging material 209. The packaging material 209 may wrap the electronic component 2101, the electronic component 2102, and the electronic component 2103, and the packaging material 209 may touch a side of the PCB 201. The packaging material 209 may package a component wrapped by the packaging material 209 to form a whole together.

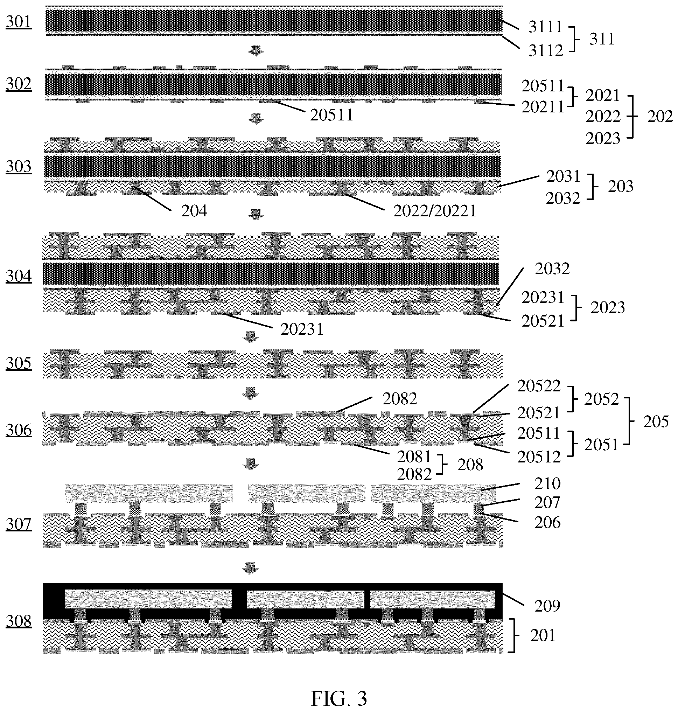

FIG. 3 to FIG. 5 are used below to describe a plurality of possible processing methods of the circuit board assembly 200 shown in FIG. 2.

FIG. 3 is a processing method of the circuit board assembly 200 shown in FIG. 2.

301: Obtain a circuit board carrier 311.

The circuit board carrier 311 may be a board component having specific mechanical strength, and may provide mechanical support for a substrate panel of the circuit board 201 to be processed. In a process of manufacturing the circuit board 201, the substrate panel of the circuit board 201 may be separated from the circuit board carrier 311. The circuit board carrier 311 may include a circuit board carrier substrate 3111 and a separable layer 3112.

The circuit board carrier substrate 3111 may provide a mechanical support function for the substrate panel of the circuit board 201. A material of the circuit board carrier substrate 3111 may be, for example, a metal material (such as copper, steel, iron, or aluminum), glass, or an organic material (such as resin).

The separable layer 3112 may be used to separate the substrate panel of the circuit board 201 from the circuit board carrier substrate 3111. A material of the separable layer 3112 may be, for example, a separable copper foil, an ultraviolet laser (ultraviolet laser, UV laser) adhesive, a pyrolytic adhesive, or a mechanical peel adhesive. The separable copper foil may refer to a copper material that can be peeled, for example, by mechanical means. The ultraviolet laser adhesive may refer to glue that is easily peeled off under irradiation of an ultraviolet laser. For example, when the glue is irradiated by an ultraviolet laser, the glue can form an easy-to-separate layer through a physical/chemical reaction, so that the glue is easily peeled off. It should be noted that, when the ultraviolet laser adhesive is used, the circuit board carrier substrate 3111 should be as transparent as possible, so that the ultraviolet laser light passes through the circuit board carrier substrate 3111. The pyrolytic adhesive may refer to glue that is easily peeled off when being heated. For example, when the glue is heated, the glue may generate a large amount of gas, so that the glue is easily peeled off. The mechanical peel adhesive may refer to glue that is sticky and easy to peel off.

302: Dispose the conducting layer 2021 on the circuit board carrier 311, where the conducting layer 2021 includes an electrical connection line 20211 and the solder pad substrate 20511.

Specifically, the electrical connection line 20211 and the solder pad substrate 20511 may be transferred or electroplated on the circuit board carrier 311. A difference between the solder pad substrate 20511 and the electrical connection line 20211 includes that, in a final finished product, the electrical connection line 20211 may be covered by a solder resist layer 208, and the solder pad substrate 20511 may be disposed outside the solder resist layer 208, and is used to be electrically connected to another circuit board or another electronic component.

A processing technology for disposing the conducting layer 2021 may be, for example, an ETS process. Specifically, the method may include: disposing an plating-resistant film in an extra area of the circuit board carrier 311, where another area other than the extra area of the circuit board carrier 311 may correspond to a final electrical connection line 20211; and attaching a conductive material to the circuit board carrier 311 in manners such as sputtering and electroless plating, where the conductive material may cover the plating-resistant film and an area that is on the electrical connection carrier 311 and in which the plating-resistant film is not disposed; then, removing the plating-resistant film, so that the electrical connection line 20211 can be formed on the circuit board carrier 311.

It should be noted that, if the separable layer 3112 is a separable copper foil, because a material of the conducting layer 2021 is the same as or similar to a material of the separable copper foil, and there is no obvious color difference between the conducting layer 2021 and the separable copper foil, it is difficult to implement automatic optical inspection (automated optical inspection, AOI) test on a modified-layer line in a subsequent processing and test process, that is, there is a test coverage hole.

As shown in FIG. 3, in order to improve efficiency of manufacturing a circuit board, circuit boards may be manufactured on both sides of the circuit board carrier 311. A circuit board 201 disposed below the circuit board carrier 311 (as shown in FIG. 3) is used as an example below to describe a processing method of the circuit board assembly 200 in FIG. 2.

303: Dispose an insulation layer 2031 on a side that is of the conducting layer 2021 and that is away from the circuit board carrier 311, and dispose the conducting layer 2022 on a side that is of the insulation layer 2031 and that is away from the conducting layer 2021, where the conducting layer 2022 includes an electrical connection line 20221.

The insulation layer 203 may include, for example, a prepreg (prepreg, PP). The prepreg may include, for example, resin and a reinforcing material, where the reinforcing material may include at least one of the following: a fiberglass cloth, a paper base, a composite material, and the like.

A manner of disposing the insulation layer 203 may include, for example, covering or press-fitting a material of the softened insulation layer 203 on the conducting layer 2021, and solidifying the material of the insulation layer 203 after cooling to form the insulation layer 203. The step of disposing the insulation layer 203 may also be referred to as a laminate process.

Optionally, before the conducting layer 2022 is disposed on the side that is of the insulation layer 2031 and that is away from the conducting layer 2021, the method further includes: disposing a via 204 on the insulation layer 2031. A manner of disposing the via 204 may be, for example, laser processing, where a laser type includes but is not limited to: carbon dioxide (CO₂) laser, ultraviolet laser, and the like.

The electrical connection line 20221 may be processed on the insulation layer 2031. A processing process of the conducting layer 2022 may include, for example, a subtractive process, a modified semi-additive process (modified semi-additive process, mSAP), a semi-additive process (semi-additive process, SAP), and the like.

The subtractive process may mean that after a conductive substrate is pre-manufactured on the insulation layer 203 (the conductive substrate is usually thick, for example, with thickness of greater than 10 µm), a photosensitive dry film is disposed on a part of the conductive substrate, to protect the part of the conductive substrate; and a redundant conductive substrate on which the photosensitive dry film is not disposed is etched to form an electrical connection line by subtracting a copper layer. The subtractive process is applicable to manufacture electrical connection lines with a line width of greater than 35 µm and a line distance of greater than 35 µm, but is usually not applicable to manufacture electrical connection lines with a line width of less than 25 µm and a line distance of less than 25 µm.

The modified semi-additive process may include: pre-manufacturing a conductive substrate (thickness of the conductive substrate is thin, for example, less than or equal to 5 µm) on the insulation layer 203; electroplating an electrical connection pattern on the conductive substrate; disposing a plating-resistant film in a redundant area in the electrical connection pattern, where an area other than the redundant area in the electrical connection pattern may correspond to a final electrical connection line; then, electroplating a conductive material on the electrical connection pattern, where the conductive material may cover an area other than the area covered by the plating-resistant film in the electrical connection pattern; and removing the plating-resistant film and removing a conductive substrate covered by the plating-resistant film, to finally obtain the electrical connection line. Different from a main object to be removed of the subtractive process, a main object to be removed of the modified semi-additive process is the plating-resistant film. The modified semi-additive process can be used to make electrical connection lines with a line width of approximately 30 µm and a line distance of approximately 30 µm.

The semi-additive process may include: electrolessly plating or sputtering a conductive substrate (thickness of the conductive substrate is thin) on the insulation layer 203; disposing a plating-resistant film in a redundant area on the conductive substrate, where an area other than the redundant area on the conductive substrate may correspond to a final electrical connection line; then, electroplating a conductive material on the conductive substrate, where the conductive material may cover an area other than the area covered by the plating-resistant film on the conductive substrate; and removing the plating-resistant film, to finally obtain the electrical connection line. Different from the modified semi-additive process, the semi-additive process does not pre-manufacture a conductive substrate, and the semi-additive process can be used to make electrical connection lines with a line width of approximately 10 µm and a line distance of approximately 10 µm. In addition, the semi-additive process has a specific requirement on the insulation layer 203. When the semi-additive process is applied, a material of the insulation layer needs to be an ajinomoto build-up film (ajinomoto build-up film, ABF) or an insulation resin material (which may be referred to as an ABF-like material for short) that has a same or similar attribute as the ABF and is compatible with the semi-additive process. The ABF usually features low rigidity and high brittleness. Improper use of the ABF is not conducive to processing-related mechanical stability of the circuit board assembly 200 shown in FIG. 2.

304: Dispose an insulation layer 2032 on a side that is of the conducting layer 2022 and that is away from the circuit board carrier 311, and dispose the conducting layer 2023 on a side that is of the insulation layer 2032 and that is away from the conducting layer 2022, where the conducting layer 2023 may include an electrical connection line 20231 and the solder pad substrate 20521.

For a specific implementation of step 304, refer to step 303 in the embodiment shown in FIG. 3. Details are not described herein again.

305: Separate the circuit board carrier 311 from the conducting layer 2021.

In this case, the conducting layer 2021, the conducting layer 2022, the conducting layer 2023, the insulation layer 2032, and the insulation layer 2031 in FIG. 2 are all processed. Subsequent processing steps no longer depend on the circuit board carrier 311.

Optionally, as described above, the circuit board carrier 311 may include the separable layer 3112, and the separable layer 3112 may be used to separate the circuit board carrier 311 from the conducting layer 2021.

In an example, a material of the separable layer 3112 is a separable copper foil. After the circuit board carrier 311 is separated from the conducting layer 2021, a part of the separable copper foil remains on the conducting layer 2021. In this case, the remaining copper foil on the conducting layer 2021 further needs to be removed (for example, in an etching manner).

306: Dispose the solder pad protective layer 20512 and the solder resist layer 2081 on the conducting layer 2021, and dispose the solder pad protective layer 20522 and the solder resist layer 2082 on the conducting layer 2023, to form the circuit board 201, where the solder pad protective layer 20512, the solder resist layer 2081, and the conducting layer 2021 are located on a same side of the circuit board 201, the solder pad protective layers 20522, the solder resist layer 2082 and the conducting layer 2023 are located on a same side of the circuit board 201, the solder pad protective layer 20512 covers the solder pad substrate 20511 to form the solder pad 2051, the solder pad protective layer 20522 covers the solder pad substrate 20521 to form the solder pad 2052, the solder resist layer 2081 covers the electrical connection line 20211, and the solder resist layer 2082 covers the electrical connection line 20231.

Specifically, step 306 may include a double-sided solder resist process and a double-sided solder pad surface processing process.

The solder resist layer 208 may be, for example, a liquid solder resist or a dry film-type solder resist.

For example, the solder pad protective layer 2052 may be, for example, electroless nickel electroless palladium immersion gold (electroless nickel electroless palladium immersion gold, ENEPIG), electroless nickel/immersion gold (electroless nickel/immersion gold, ENIG), or organic solderability preservatives (organic solderability preservatives, OSP).

307: Solder and fasten the electronic component 210 to the solder pad 2051.

For example, the solder 206 may be disposed on the solder pad 2051, and the electrical holder 207 electrically connected to the electronic component 210 is disposed on the electronic component 210. The solder 206 is melted in a soldering manner, so that the electrical holder 207 can be fastened to the solder pad 2051.

308: Dispose a packaging material 209, where the packaging material 209 may wrap a periphery of the electronic component 210, and touch a side that is of the circuit board 201 and that is close to the electronic component 210.

A material of the packaging material 209 may be, for example, resin or ceramic.

So far, the circuit board assembly 200 shown in FIG. 2 may be obtained by using the processing method shown in FIG. 3.

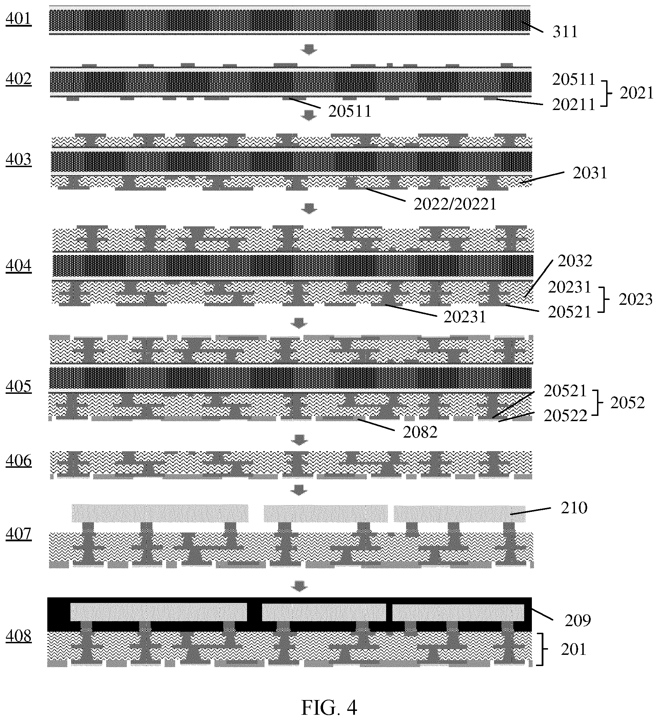

FIG. 4 is another processing method of the circuit board assembly 200 shown in FIG. 2.

401: Obtain a circuit board carrier 311.

402: Dispose the conducting layer 2021 on the circuit board carrier 311, where the conducting layer 2021 includes an electrical connection line 20211 and the solder pad substrate 20511.

403: Dispose an insulation layer 2031 on a side that is of the conducting layer 2021 and that is away from the circuit board carrier 311, and dispose the conducting layer 2022 on a side that is of the insulation layer 2031 and that is away from the conducting layer 2021, where the conducting layer 2022 includes an electrical connection line 20221.

404: Dispose the insulation layer 2032 on a side that is of the conducting layer 2022 and that is away from the circuit board carrier 311, and dispose the conducting layer 2023 on a side that is of the insulation layer 2032 and that is away from the conducting layer 2022, where the conducting layer 2023 includes an electrical connection line 20231 and the solder pad substrate 20521.

For a specific implementation of steps 401 to 404, refer to steps 301 to 304 in the embodiment shown in FIG. 3. Details are not described herein again.

405: Dispose a solder pad protective layer 20522 and a solder resist layer 2082 on the conducting layer 2023, where the solder pad protective layer 20522 covers the solder pad substrate 20521 to form the solder pad 2052, and the solder resist layer 2082 covers the electrical connection line 20231.

For a specific implementation of step 405, refer to step 306 in the embodiment shown in FIG. 3. Details are not described herein again.

406: Separate the circuit board carrier 311 from the conducting layer 2021.

For a specific implementation of step 406, refer to step 305 in the embodiment shown in FIG. 3. Details are not described herein again.

407: Solder and fasten the electronic component 210 to the solder pad substrate 20511.

For a specific implementation of step 407, refer to step 307 in the embodiment shown in FIG. 3. Details are not described herein again. FIG. 3 shows a double-sided solder resist process, that is, solder resist layers and solder pad protective layers are disposed on both sides of the circuit board 201. Compared with the embodiment shown in FIG. 3, the example in FIG. 4 shows a single-sided solder resist process, that is, the solder resist layer 2082 and the solder pad protective layer 20522 are disposed only on the conducting layer 2023, and a solder resist layer and a solder pad protective layer may not be disposed on the conducting layer 2021. A reason why a solder resist layer and a solder pad protective layer may not be disposed on the conducting layer 2021 may include: It can be learned from the following that, in 408 after 407, both the electrical connection line 20211 and the solder pad substrate 20511 on the conducting layer 2021 may be covered and protected by a packaging material 209 in 408. Therefore, the solder resist layer 2081 and the solder pad protective layer 20512 shown in FIG. 3 may not be necessary in the example shown in FIG. 4.

408: Dispose the packaging material 209, where the packaging material 209 wraps a periphery of the electronic component 210, and touches a side that is of the circuit board and that is close to the electronic component 210.

For a specific implementation of step 409, refer to step 308 in the embodiment shown in FIG. 3. Details are not described herein again.

On a current mass production level of the industry, a total board thickness of the three-layer (3L) ETS circuit boards shown in FIG. 2 to FIG. 4 may be greater than 85 µm. It may be learned from the foregoing method that, after the circuit board carrier is separated from the conducting layer, the following processes further need to be performed: etching the remaining separable copper foil, solder resist processing, surface processing of the solder pad, a circuit board test, fastening the electronic component, plastic packaging, and the like. Because the thickness of the circuit board is thin, the circuit board does not have robust strength. Therefore, in a subsequent processing process, the circuit board may be scrapped due to cracks. This is not conducive to mass production of the circuit board. As described above, with the requirement for thinner substrates having increased compactness, if the thickness of the circuit board continues to be reduced (for example, lower than 85 µm), thickness of the insulation layer is very thin, rigidity of the circuit board is low, operational performance of the circuit board in subsequent material processing and packaging becomes poor, and the circuit board is prone to be bent, stuck, folded, and cracked, which leads to problems such as scrapping of the circuit board and making it difficult to implement mass production. In addition, it is more difficult to implement thinner circuit boards.

In addition, if the insulation layer is a PP medium, thickness of a single-layer insulation layer may be greater than 16 µm. If the thickness needs to be further thinned, an ABF-like material without fiberglass is required because thickness reduction and press-fitting and adhesive filling of fiberglass are limited. A line width of an ETS-layer line may be approximately 10 µm, and a line distance of the ETS-layer line may be approximately 10 µm (that is, an ETS layer has a 10/10 µm line). However, a highest line compactness of another conducting layer other than the ETS layer can only reach approximately 15/15 µm. If electrical connection lines of the another conducting layer other than the ETS layer needs to be more compact, the more compact electrical connection lines need to be manufactured by using an SAP process. In this case, an insulation layer material corresponding to the more compact electrical connection lines also needs to use an ABF-like material. The ABF without fiberglass usually features low rigidity and high brittleness. Using the ABF is not conducive to mechanical stability of a circuit board in processing.

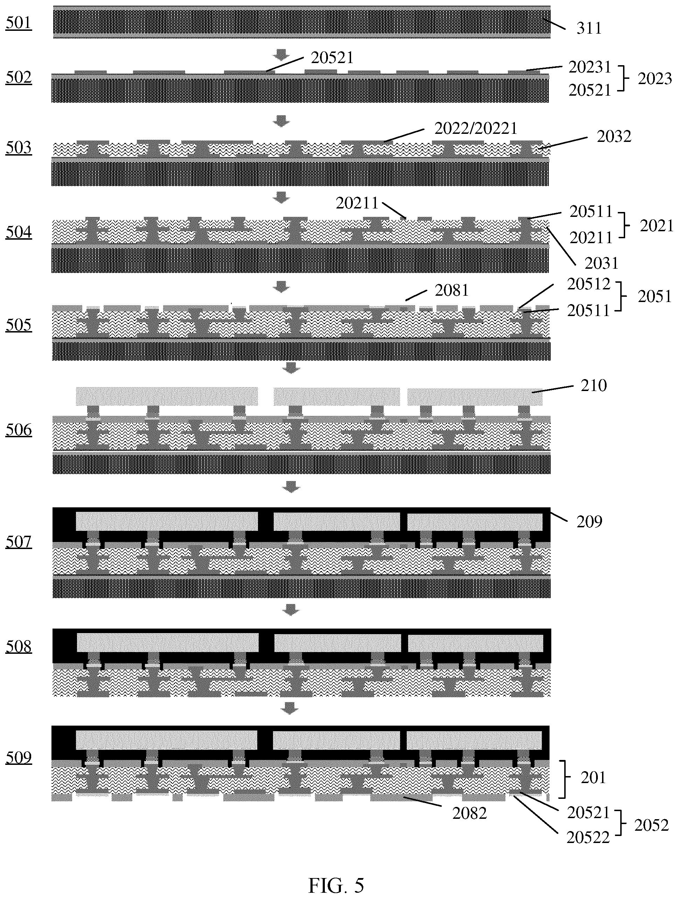

FIG. 5 is still another processing method of the circuit board assembly 200 shown in FIG. 2.

501: Obtain a circuit board carrier 311.

502: Dispose the conducting layer 2023 on the circuit board carrier 311, where the conducting layer 2023 includes an electrical connection line 20231 and the solder pad substrate 20521.

503: Dispose an insulation layer 2032 on a side that is of the conducting layer 2023 and that is away from the circuit board carrier 311, and dispose the conducting layer 2022 on a side that is of the insulation layer 2032 and that is away from the conducting layer 2023, where the conducting layer 2022 includes an electrical connection line 20221.

504: Dispose an insulation layer 2031 on a side that is of the conducting layer 2022 and that is away from the circuit board carrier 311, and dispose the conducting layer 2021 on a side that is of the insulation layer 2031 and that is away from the conducting layer 2022, where the conducting layer 2021 includes an electrical connection line 20211 and the solder pad substrate 20511.

For a specific implementation of steps 501 to 504, refer to steps 301 to 304 in the embodiment shown in FIG. 3. Details are not described herein again.

505: Dispose a solder pad protective layer 20512 and the solder resist layer 2081 on the conducting layer 2021, where the solder pad protective layer 20512 covers the solder pad substrate 20511 to form the solder pad 2051, and the solder resist layer 2081 covers the electrical connection line 20211.

For a specific implementation of step 505, refer to step 306 in the embodiment shown in FIG. 3. Details are not described herein again.

506: Solder and fasten the electronic component 210 to the solder pad 2051.

For a specific implementation of step 506, refer to step 307 in the embodiment shown in FIG. 3. Details are not described herein again.

507: Dispose the packaging material 209, where the packaging material 209 wraps a periphery of the electronic component 210, and touches a side that is of the circuit board and that is close to the electronic component 210.

For a specific implementation of step 507, refer to step 308 in the embodiment shown in FIG. 3. Details are not described herein again.

508: Separate the circuit board carrier 311 from the conducting layer 2023.

For a specific implementation of step 508, refer to step 305 in the embodiment shown in FIG. 3. Details are not described herein again.

After step 508, a packaged circuit board assembly can be obtained. However, the circuit board assembly cannot be used normally. As shown in FIG. 5, the electrical connection line 20231 on the conducting layer 2032 is exposed to air, and consequently, the electrical connection line 20231 is easily contaminated by foreign objects and is also easily corroded by an external environment. Therefore, a reliability risk exists. The circuit board assembly obtained only through steps 501 to 508 cannot be a final product. Optionally, step 509 may be further included.

509: Dispose a solder pad protective layer 20522 and the solder resist layer 2082 on the conducting layer 2023, to form the circuit board 201, where the solder pad protective layer 20522 covers the solder pad substrate 20521 to form the solder pad 2052, the solder resist layer 2082 covers the electrical connection line 20231, the solder pad protective layer 20522, the solder resist layer 2082, and the conducting layer 2023 are located on a same side of the circuit board 201, and the solder pad protective layers 20512, the solder resist layer 2081 and the conducting layer 2021 are located on a same side of the circuit board 201.

For a specific implementation of step 509, refer to step 306 in the embodiment shown in FIG. 3. Details are not described herein again.

Before step 509 is performed, the electrical connection line 20231 on the conducting layer 2023 is always exposed to air, and consequently, the electrical connection line 20231 is easily oxidized or contaminated. Therefore, it is difficult to obtain a circuit board assembly of good quality by using the processing method shown in FIG. 5, and a reliability risk also exists.

In steps 501 to 505, the substrate panel of the circuit board assembly may be usually processed in a manner of a large size and a large-size assembled board. Before step 506 is performed, the substrate panel of the circuit board assembly is usually cut into small-sized strips, to facilitate packaging in a packaging factory.

In a possible case, to adapt to a processing form of a large size and a large-sized assembled board in step 509, in a packaging process from steps 506 to 508, the substrate panel of the circuit board assembly needs to be maintained in a state of a large size and a large-sized assembled board. For example, the packaging factory may use panel-level packaging (panel-level package, PLP). This increases processing difficulty of steps 506 to 508, and a conventional packaging line is usually difficult to be compatible with processing of a substrate panel of a large size and a large-sized assembled board.

In another possible case, to adapt to a processing form of a small-sized strip substrate panel in steps 506 to 508, the small-sized strip substrate panel needs to be specially processed in step 509. For example, a solder resist production line and a solder pad surface processing production line for small-size substrates are specially configured. This increases processing difficulty of step 509 because it is difficult for production and processing lines of solder resist finish machining, solder pad surface processing, and the like to be compatible with processing of the small-sized strip substrate panel.

In still another possible case, to adapt to both processing of small-sized strips in steps 506 to 508 and processing of a large size and a large-sized assembled board in step 509, a possible method is to add a mold assembly process after step 508 and before step 509, that is, assemble small-size strip substrates into a large-size board by using a mold. This increases a processing process of the circuit board assembly and increases processing difficulty of step 509.

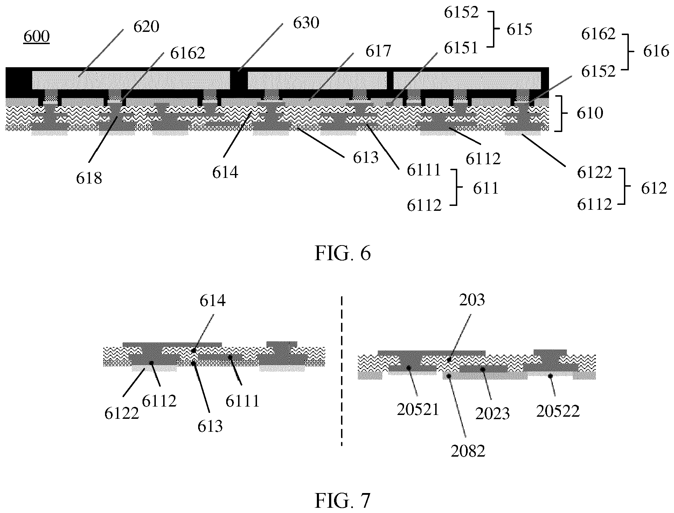

FIG. 6 shows a circuit board assembly 600 according to an embodiment of this application.

The circuit board assembly 600 includes a first circuit board 610 and an electronic component 620 disposed on the first circuit board 610. As shown in FIG. 6, the electronic component 620 may be fastened to the first circuit board 610 by soldering. An electrical connector between the electronic component 620 and the first circuit board 610 may include at least one of the following: a solder, an electrical holder, a via, and the like.

The circuit board assembly 600 may further include a packaging material 630. The packaging material 630 may wrap the electronic component 620 and touch a side of the first circuit board 610. The packaging material 630 may be used to protect the electronic component 620, and enable the electronic component 620 to have a solid connection to the first circuit board 610.

The first circuit board 610 may include a plurality of conducting layers (for example, a conducting layer 611 and a conducting layer 615 shown in FIG. 6) and at least one insulation layer 614 that are disposed in a spaced manner. One insulation layer 614 is disposed between two adjacent conducting layers. When the first circuit board 610 includes a plurality of insulation layers 614, one conducting layer is disposed between two adjacent insulation layers 614. The first circuit board 610 shown in FIG. 6 includes three conducting layers and two insulation layers 614. It should be understood that FIG. 6 is merely an example, and the first circuit board 610 may further include more or fewer conducting layers. When the first circuit board 610 includes a larger quantity of conducting layers, a highly complex electrical connection line can be implemented, so that the electronic component 620 electrically connected to the first circuit board 610 can implement a complex function. However, increasing the quantity of conducting layers also increases a quantity of insulation layers 614, increasing an overall thickness of the first circuit board 610.

A conducting layer located on a side of the first circuit board 610 may include an electrical connection line (an electrical connection line 6111 and an electrical connection line 6151 shown in FIG. 6) and a solder pad substrate (a solder pad substrate 6112 and a solder pad substrate 6152 shown in FIG. 6). The electrical connection line may be electrically connected to the solder pad substrate, and further electrically connected to the electronic component 620 disposed on the first circuit board 610.

In an example, as shown in FIG. 6, an electrical connection line and a solder pad substrate on a same conducting layer may be respectively located at locations with different heights (that is, different locations in thickness direction) in the first circuit board 610, as locations of the conducting layer 611, the electrical connection line 6111, and the solder pad substrate 6112 shown in FIG. 6.

In an example, an electrical connection line and a solder pad substrate on a same conducting layer may be respectively located at locations with a same height in the first circuit board 610, as locations of the conducting layer 615, the electrical connection line 6151, and the solder pad substrate 6152 shown in FIG. 6.

The first circuit board 610 may further include a conducting layer having only an electrical connection line. Compared with a conducting layer having an electrical connection line and a solder pad substrate, the conducting layer having only an electrical connection line is usually located inside the first circuit board 610.

The first circuit board 610 may further include a solder pad protective layer (for example, a solder pad protective layer 6122 and a solder pad protective layer 6162 shown in FIG. 6). The solder pad protective layer can cover the solder pad substrate to avoid oxidation caused by exposing the solder pad substrate to air as much as possible. In addition, the solder pad protective layer may further include a material that helps improve soldering performance. For example, the material of the solder pad protective layer may be, for example, electroless nickel electroless palladium immersion gold (electroless nickel electroless palladium immersion gold, ENEPIG), electroless nickel/immersion gold (electroless nickel/immersion gold, ENIG), or organic solderability preservatives (organic solderability preservatives, OSP). The solder pad substrate and the solder pad protective layer may be used to form a solder pad (for example, a solder pad 612 and a solder pad 616 shown in FIG. 6) on the first circuit board 610. The solder pad may be used to solder and fasten the electronic component 620 on the first circuit board 610.

The first circuit board 610 may further include a solder resist layer (for example, a solder resist layer 613 and a solder resist layer 617 shown in FIG. 6). The solder resist layer can cover the electrical connection line to avoid oxidation caused by exposing the electrical connection line to air as much as possible. It should be understood that the solder resist layer and the solder pad protective layer may separately cover different areas of the conducting layer, so that the solder resist layer further helps limit random flow of the solder.

The following defines two conducting layers located on two sides of the first circuit board 610 as a first conducting layer 611 and a second conducting layer 615. As shown in FIG. 6, the first conducting layer 611 may be, for example, a conducting layer that is of the first circuit board 610 and that is farthest away from the electronic component 620. For example, the second conducting layer 615 may be a conducting layer that is of the first circuit board 610 and that is closest to the electronic component 620. The first conducting layer 611 and the second conducting layer 615 are spaced by at least one insulation layer 614.

The first circuit board 610 further includes at least one first via 618, and the at least one first via 618 is used to implement an electrical connection between the first conducting layer 611 and the second conducting layer 615. For example, a first via plate is disposed on the first conducting layer 611, a second via plate is disposed on the second conducting layer 615, and the first via 618 is connected between the first via plate and the second via plate.

The first conducting layer 611 may include a first solder pad substrate 6112 and a first electrical connection line 6111, and the first solder pad substrate 6112 is electrically connected to the first electrical connection line 6111. A first solder pad protective layer 6122 and a first solder resist layer 613 are disposed on the first conducting layer 611. The first solder pad protective layer 6122 covers the first solder pad substrate 6112 to form a first solder pad 612, and the first solder resist layer 613 covers the first electrical connection line 6111. The first solder pad protective layer 6122 covers a first area on the first conducting layer 611, and the first solder resist layer 613 covers a second area on the first conducting layer 611. The first area is different from the second area. In an example, the first area and the second area do not intersect, do not cross, or are not overlapped by each other. In this embodiment of this application, the first solder resist layer 613 may use a photo imageable dielectric (photo imageable dielectric, PID) material.

In addition, to improve mechanical stability of the first solder pad, the first solder resist layer may cover a part of the first solder pad substrate or a part of the first solder pad protective layer, that is, the first area and the second area may cross. It should be noted that, it can be learned from the foregoing processing process that the first solder resist layer does not cover the first solder pad substrate or the first solder pad protective layer at the beginning. To enable the first solder resist layer to cover the part of the first solder pad substrate or the part of the first solder pad protective layer, a new solder resist material further needs to be disposed on the first solder pad substrate or the first solder pad protective layer.

In one example, the first electrical connection line 6111 may be connected between the first via 618 and the first solder pad substrate 6112. A cross section shape of the first via 618 may be, for example, any shape such as a circle, a rectangle, or an oval.

Similarly, the second conducting layer 615 may include a second solder pad substrate 6152 and a second electrical connection line 6151, and the second solder pad substrate 6152 is electrically connected to the second electrical connection line 6151. A second solder pad protective layer 6162 and a second solder resist layer 617 are disposed on the second conducting layer 615. The second solder pad protective layer 6162 covers the second solder pad substrate 6152 to form a second solder pad 616, and the second solder resist layer 617 covers the second electrical connection line 6151. The second solder pad protective layer 6162 covers a third area on the second conducting layer 615, and the second solder resist layer 617 covers a fourth area on the second conducting layer 615. The third area is different from the fourth area. In an example, the third area and the fourth area do not intersect, do not cross, or are not overlapped by each other. Optionally, the second solder pad protective layer 6162 and the second solder resist layer 617 may not be disposed on the second conducting layer 615.

Optionally, a solder pad such as a solder-mask defined (solder-mask defined, SMD) solder pad, a non-solder mask defined (non-solder mask defined, NSMD) solder pad, or a gold finger (gold finger) solder pad may be further disposed on the second conducting layer 615.

FIG. 7 shows a partial schematic diagram of a difference between the circuit board assembly 600 shown in FIG. 6 and the circuit board assembly 200 shown in FIG. 2.

With reference to the left diagram in FIG. 7, it can be learned that, in the circuit board assembly 600 shown in FIG. 6, the first solder pad substrate 6112 and the first electrical connection line 6111 may be respectively located at locations with different heights in the first circuit board 610. A material of the first solder resist layer 613 may use a photo imageable dielectric (photo imageable dielectric, PID) material. The first solder resist layer 613 may wrap a side surface of the first solder pad substrate 6112, and the first solder pad substrate 6112 may include an end surface that is connected to or touches the first electrical connection line 6111. In this application, the side surface may be a surface vertically disposed relative to the end surface. In other words, the first solder pad substrate 6112 may be embedded in the first solder resist layer 613, and an end face of the first solder pad substrate 6112 is exposed.

With reference to the right diagram in FIG. 7, it can be learned that, in the circuit board assembly 600 shown in FIG. 2, the first solder pad substrate 6112 and the first electrical connection line 6111 may be located at locations with a same height in the first circuit board 610. The insulation layer 614 of the first circuit board 610 may wrap a side surface of the first solder pad substrate 6112. The circuit board assembly 600 shown in FIG. 2 may not limit material selection of the first solder resist layer 613.

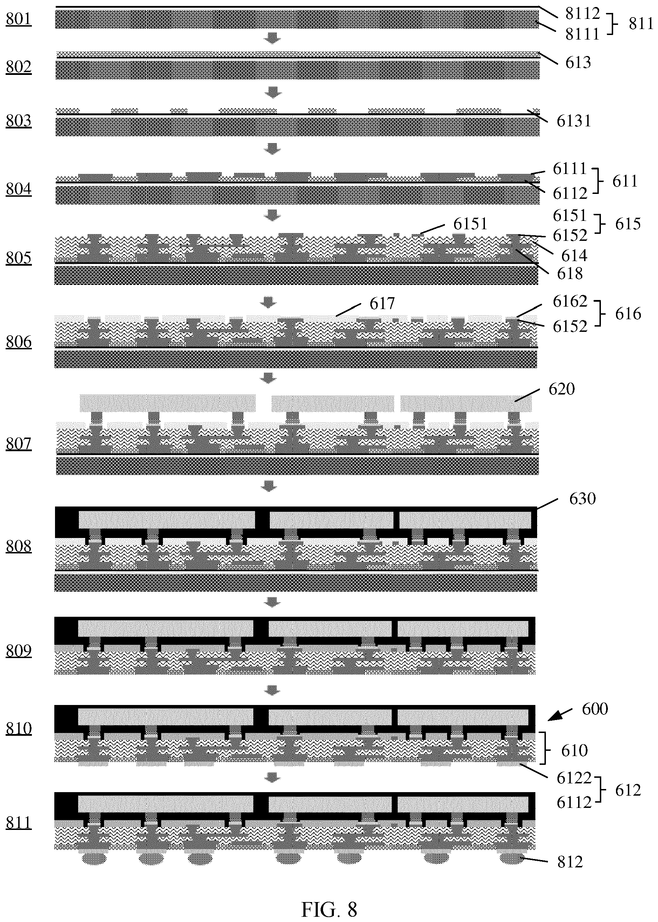

Because a processing technology of a structure of the circuit board assembly 600 shown in FIG. 6 is different from a processing technology of the circuit board assembly 600 shown in FIG. 2, the structure of the circuit board assembly 600 shown in FIG. 6 is different from the structure of the circuit board assembly 600 shown in FIG. 2. With reference to FIG. 8 to FIG. 9, the following describes a processing method of the circuit board assembly 600 shown in FIG. 6 according to an embodiment of this application.

FIG. 8 is a processing method of the circuit board assembly 600 shown in FIG. 6.

801: Obtain a circuit board carrier 811.

The circuit board carrier 811 may be a board component having specific mechanical strength, and may provide mechanical support for a substrate panel of the first circuit board 610 to be processed. In a process of manufacturing the first circuit board 610, the substrate panel of the first circuit board 610 may be separated from the circuit board carrier 811. The circuit board carrier 811 may include a circuit board carrier substrate 8111 and a separable layer 8112.

The circuit board carrier substrate 8111 may provide a mechanical support function for the substrate panel of the first circuit board 610. A material of the circuit board carrier substrate 8111 may be, for example, a metal material (such as copper, steel, iron, or aluminum), glass, or an organic material (such as resin).

The separable layer 8112 may be used to separate the substrate panel of the first circuit board 610 from the circuit board carrier substrate 8111. A material of the separable layer 8112 may be, for example, a separable copper foil (for example, a double-layer copper foil), an ultraviolet laser (ultraviolet laser, UV laser) adhesive, a pyrolytic adhesive, or a mechanical peel adhesive. The separable copper foil may refer to a copper material that can be peeled, for example, by mechanical means. The ultraviolet laser adhesive may refer to glue that is easily peeled off under irradiation of an ultraviolet laser. For example, when the glue is irradiated by an ultraviolet laser, the glue can form an easy-to-separate layer through a physical/chemical reaction, so that the glue is easily peeled off. It should be noted that, when the ultraviolet laser adhesive is used, the circuit board carrier substrate 8111 should be as transparent as possible, so that the ultraviolet laser light passes through the circuit board carrier substrate 8111. The pyrolytic adhesive may refer to glue that is easily peeled off when being heated. For example, when the glue is heated, the glue may generate a large amount of gas that can lift the glue, so that the glue is easily peeled off. The mechanical peel adhesive may refer to glue that is sticky and easy to peel off.

802: Dispose the first solder resist layer 613 on the circuit board carrier 811, where a material of the first solder resist layer 613 may include a photo imageable dielectric (photo imageable dielectric, PID) material.

The solder resist layer may be, for example, a liquid solder resist or a dry film-type solder resist. A manner of disposing the first solder resist layer 613 on the circuit board carrier 811 may include: applying a liquid PID on a surface of the circuit board carrier 811, or pressing or press-fitting a PID film on the circuit board carrier 811.

803: Expose the first solder resist layer 613, so that a cavity 6131 corresponding to the first solder pad substrate 6112 is formed on the first solder resist layer 613.

It can be learned from an attribute of the PID that, when the PID is irradiated, a part of the first solder resist layer 613 may be solidified or reserved, and the other part of the first solder resist layer 613 is easily separated or disappears. The cavity 6131 formed on the first solder resist layer 613 may be used to dispose the first solder pad substrate 6112. The reserved solder resist layer material may be used to carry the first electrical connection line 6111 that is subsequently manufactured.

804: Dispose the first conducting layer 611 on the first solder resist layer 613, where the first conducting layer 611 includes the first electrical connection line 6111 and the first solder pad substrate 6112, the first solder pad substrate 6112 is disposed in the cavity 6131 on the first solder resist layer 613, and the first electrical connection line 6111 is disposed on a side that is of the first solder resist layer 613 and that is away from the circuit board carrier 811.

The first solder pad substrate 6112 may be formed through pattern plating (pattern plating) inside the cavity 6131 on the first solder resist layer 613, and the first electrical connection line 6111 may be formed through pattern plating outside the cavity 6131 on the first solder resist layer 613. Therefore, in a final finished product, the first solder resist layer 613 may cover the first electrical connection line 6111, but cannot completely cover the first solder pad substrate 6112.

A processing technology for disposing the conducting layer may be, for example, a semi-additive process (semi-additive process, SAP).

The semi-additive process may include: processing a conductive substrate (thickness of the conductive substrate is thin) on the first solder resist layer 613 through electroless plating or sputtering, electroless plating combined with electroplating, or sputtering combined with electroplating; disposing a plating-resistant film in a redundant area on the conductive substrate, where an area other than the redundant area on the conductive substrate may correspond to a final electrical connection line; then, electroplating a conductive material on the conductive substrate, where the conductive material may cover an area other than the area covered by the plating-resistant film on the conductive substrate; and removing the plating-resistant film and removing a conductive substrate covered by the plating-resistant film, to finally obtain the electrical connection line. The semi-additive process does not pre-manufacture a conductive substrate, and the semi-additive process can be used to make electrical connection lines with a line width of approximately 10 µm and a line distance of approximately 10 µm. In addition, the semi-additive process has a specific requirement on the first solder resist layer 613. Because a material of the first solder resist layer 613 is the PID, the semi-additive process may be applied.

805: Dispose, on the first conducting layer 611, at least one insulation layer 614 and at least one conducting layer in a spaced manner, and the first via 618 electrically connected to the first conducting layer 611, where any insulation layer 614 is between two adjacent conducting layers, the at least one conducting layer includes the second conducting layer 615, and the second conducting layer 615 includes the second electrical connection line 6151 and the second solder pad substrate 6152.

That is, in a final finished product, the first circuit board 610 may include at least two conducting layers and at least one insulation layer 614, and an electrical connection between any two conducting layers may be implemented through the first via 618. The first conducting layer 611 and the second conducting layer 615 may be two outermost conducting layers of the first circuit board 610.

It should be noted that, in the second conducting layer 615, the second electrical connection line 6151 and the second solder pad substrate 6152 may be located at locations with a same height on the first circuit board 610, or the second electrical connection line 6151 and the second solder pad substrate 6152 may be located at locations with different heights in the first circuit board 610. This may not be limited in this embodiment of this application.

For a specific implementation of disposing the insulation layer 614, the conducting layer, and the first via 618, refer to steps 303 and 304 in the embodiment shown in FIG. 3. Details are not described herein again. In addition, a manner of disposing the first via 618 may alternatively be, for example, a laser blind-hole making and copper plating and filling process, a PID windowing and copper plating and filling process, or a copper column process.

In this embodiment of this application, a material of the insulation layer 614 may include at least one of the following: a PP, an ABF, and a PID.

806: Dispose the second solder pad protective layer 6162 and the second solder resist layer 617 on the second conducting layer 615, where the second solder pad protective layer 6162 covers the second solder pad substrate 6152 to form the second solder pad 616, and the second solder resist layer 617 covers the second electrical connection line 6151.

The second solder resist layer 617 may be, for example, a liquid solder resist or a dry film-type solder resist.

For example, the second solder pad protective layer 6162 may be, for example, electroless nickel electroless palladium immersion gold (electroless nickel electroless palladium immersion gold, ENEPIG), electroless nickel/immersion gold (electroless nickel/immersion gold, ENIG), or organic solderability preservatives (organic solderability preservatives, OSP).

807: Solder and fasten the electronic component 620 to the second solder pad 616.

For example, a solder may be disposed on the second solder pad 616, and an electrical holder electrically connected to the electronic component 620 is disposed on the electronic component 620. The solder is melted in a soldering manner, so that the electrical holder can be fastened to the second solder pad 616.

808: Dispose the packaging material 630, where the packaging material 630 wraps a periphery of the electronic component 620 and touches the second solder resist layer 617.

A material of the packaging material 630 may be, for example, resin or ceramic.

809: Separate the circuit board carrier 811 from the first solder resist layer 613.

Optionally, the circuit board carrier 811 includes the circuit board carrier substrate 8111 and the separable layer 8112, and the method further includes: removing the remaining separable layer 8112 from the first solder resist layer 613.

As described above, the circuit board carrier 811 may include the separable layer 8112, and the separable layer 8112 may be used to separate the circuit board carrier 811 from the conducting layer.

In an example, a material of the separable layer 8112 is a separable copper foil. After the circuit board carrier 811 is separated from the first solder resist layer 613, a part of the separable copper foil may remain on the first solder resist layer 613. In this case, the remaining copper foil on the first solder resist layer 613 further needs to be removed (for example, in an etching manner). In another example, the circuit board carrier substrate 8111 is transparent, and the separable layer 8112 is an ultraviolet laser adhesive. When the circuit board carrier 811 is separated from the first solder resist layer 613, ultraviolet light may be irradiated on the ultraviolet laser adhesive on a side that is of the circuit board carrier 811 and that is away from the first solder resist layer 613. When the ultraviolet laser adhesive is irradiated by the ultraviolet light, a state of the ultraviolet laser adhesive may change, to separate the ultraviolet laser adhesive from the first solder resist layer 613. Using the ultraviolet laser adhesive helps reduce a remaining separable material on the first solder resist layer 613. Compared with the separable copper foil, the ultraviolet laser adhesive used helps reduce a processing process of the circuit board assembly 600, and helps reduce a requirement on a processing capability of a packaging factory.

In still another example, the separable layer 8112 is a pyrolytic adhesive, and the separable layer 8112 may be separated from the first solder resist layer 613 in a heating manner. Using the pyrolytic adhesive helps reduce a remaining separable material on the first solder resist layer 613.

In another example, the separable layer 8112 is a mechanical peel adhesive, and the separable layer 8112 may be separated from the first solder resist layer 613 in a mechanical peeling manner. Using the mechanical peel adhesive helps reduce a remaining separable material on the first solder resist layer 613.

810: Dispose the first solder pad protective layer 6122 on the first solder pad substrate 6112, to form the first solder pad 612.

After the circuit board carrier 811 is separated from the first solder resist layer 613, the first solder pad substrate 6112 is exposed. Therefore, solder pad surface processing may be performed on the first solder pad substrate 6112. For example, the first solder pad protective layer 6122 may be disposed on the first solder pad substrate 6112 by disposing a coat.

Optionally, as shown in 811 in FIG. 8, the method further includes: disposing a solder 812 on the first solder pad 612.

A method for disposing the solder 812 may be, for example, solder balling, to help solder and fasten the first circuit board 610 to another circuit board or another electronic component.

In addition, in addition to the manner of disposing the first solder pad protective layer 6122 shown in FIG. 8, after step 803 is performed and before step 804 is performed, the first solder pad protective layer 6122 may be disposed inside the cavity 6131 on the first solder resist layer 613. In step 804, the first solder pad substrate 6112 may be directly disposed on the first solder pad protective layer 6122.

It should be understood that the step of separating the circuit board carrier 811 from the first solder resist layer 613 may alternatively be performed after step 806 or step 807. This increases a risk of damage to the circuit board, but increases flexibility of process steps.

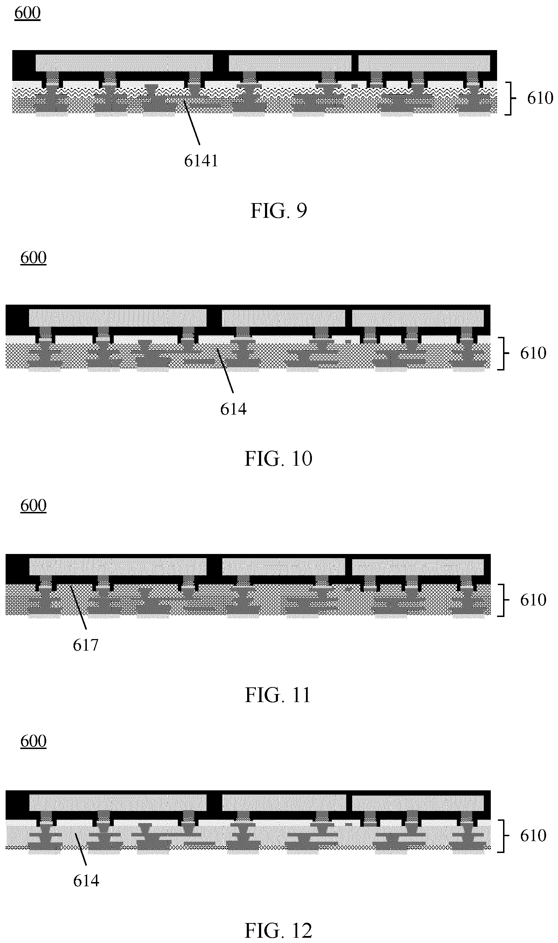

FIG. 9 shows a circuit board assembly 600 according to an embodiment of this application. A difference from the circuit board assembly 600 shown in FIG. 6 includes: A first circuit board 610 may include a first insulation layer 6141, and a material of the first insulation layer 6141 is a PID. Because the PID can be compatible with an SAP process, this facilitates implementation of compact electrical connection lines. In addition, the PID may form a cavity of any shape by exposure and development. This helps form a blind hole of any shape.

It can be learned from the foregoing content that compactness of the electrical connection lines can be improved by using the SAP process. For a conducting layer at which electrical connection lines are not required to be compact, the conducting layer may be disposed on an insulation layer made of a PP material through a subtractive process, an mSAP, or the like, or disposed on an insulation layer made of an ABF material through a subtractive process, an mSAP, an SAP, or the like. In other words, this embodiment of this application further provides a circuit board assembly having insulation layers of different materials. This helps to balance compactness of electrical connection lines and an overall mechanical strength of the circuit board assembly.

FIG. 10 shows a circuit board assembly 600 according to an embodiment of this application. A difference from the circuit board assembly 600 shown in FIG. 9 includes: A material of all insulation layers 614 in a first circuit board 610 is a PID. Because the PID may be compatible with the SAP process, using the PID as the material of the insulation layer helps implement compact electrical connection lines on all conducting layers in the entire first circuit board 610. In addition, the PID may form any cavity by exposure and development. This helps form a blind hole of any shape in the entire first circuit board 610.

FIG. 11 shows a circuit board assembly 600 according to an embodiment of this application. A difference from the circuit board assembly 600 shown in FIG. 10 includes: A material of a second solder resist layer 617 in a first circuit board 610 is a PID. Using the PID helps flexibly implement a groove design of the first circuit board 610 (that is, a cavity (cavity) structure may be formed on the circuit board). For example, precision of the groove may be higher, and a shape of the groove may be more flexible. A groove of the first circuit board 610 may be used to dispose an electronic component. An electronic component with a high height is disposed in the groove. This helps reduce an overall height of the circuit board assembly, and further helps improve assembly integration of the circuit board assembly. In addition, if the electronic component located in the groove further includes a first pin, the first pin is located on a side that is of the electronic component and that is away from the first circuit board 610, and the circuit board assembly further includes a first electrical connection wire electrically connected between the first pin and the first circuit board 610, the groove further helps reduce a length of the electrical connection line, and helps improve signal transmission quality of the electrical connection wire. In addition, because the second solder resist layer 617 is the PID, and a metal material such as copper can be directly deposited on the PID, an electrical holder or a lead-out metal pad of another shape may be manufactured on the second solder resist layer 617. This helps reduce difficulty in processing the circuit board assembly.

FIG. 12 shows a circuit board assembly 600 according to an embodiment of this application. A difference from the circuit board assembly 600 shown in FIG. 10 includes: A material of all insulation layers 614 included in a first circuit board 610 is an ABF. Because the ABF is compatible with the SAP, using the ABF as the material of the insulation layer not only helps obtain electrical connection lines with high compactness, but also helps reduce costs of manufacturing the first circuit board 610.

It should be understood that, according to the embodiments shown in FIG. 6 to FIG. 12, a plurality of other possible embodiments may be obtained. For example, in addition to the insulation layer 614 of the ABF material, the first circuit board 610 may further include an insulation layer 614 of another material. In other words, the circuit board assembly 600 or the first circuit board 610 may include at least one second insulation layer, and a material of the second insulation layer is the ABF.

The first circuit board 610 shown in FIG. 6 to FIG. 12 may be applied to another type of circuit board assembly.

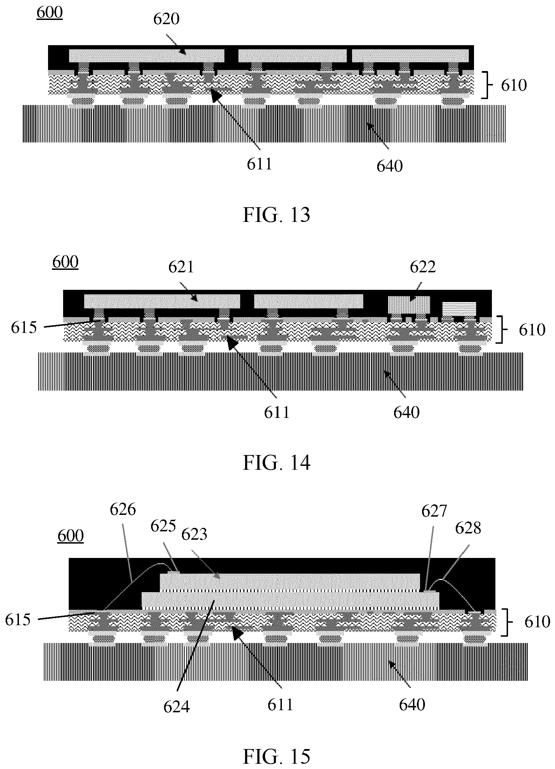

FIG. 13 is a schematic diagram of a structure of a circuit board assembly 600 according to an embodiment of this application. The circuit board assembly 600 belongs to system in package (system in package, SiP) having a flip chip (flip chip, FC). A difference between the circuit board assembly 600 shown in FIG. 13 and the circuit board assembly 600 shown in FIG. 6 may include: A side that is of a first circuit board 610 and that has a first conducting layer 611 may be soldered and fastened to a second circuit board 640 (for example, a mainboard, a frame board, or a base board). In addition, in an example, the second circuit board 640 shown in FIG. 13 may also be obtained by processing through steps 801 to 806 shown in FIG. 8.

FIG. 14 is a schematic diagram of a structure of a circuit board assembly 600 according to an embodiment of this application. The circuit board assembly 600 belongs to SiP having a flip-mounted active electronic component 621 and a surface-mounted-technology (surface mounted technology, SMT) passive electronic component 622. A difference between the circuit board assembly 600 shown in FIG. 14 and the circuit board assembly 600 shown in FIG. 13 may include: The active electronic component 621 (or may be referred to as an active component) and the passive electronic component 622 (or may be referred to as a passive component) may be disposed on a side that is of a first circuit board 610 and that has a second conducting layer 615. The active electronic component 621 may refer to a component that needs to provide power supply, for example, a chip, a signal amplifier, or a sensor. The passive electronic component 622 may refer to a component that does not need to provide power supply, for example, a resistor, an inductor, or a capacitor.

FIG. 15 is a schematic diagram of a structure of a circuit board assembly 600 according to an embodiment of this application. The circuit board assembly 600 is a circuit board assembly 600 having a ball grid array, multi-chip stacking, and wire bonding (wire bonding, WB) interconnection. A difference between the circuit board assembly 600 shown in FIG. 15 and the circuit board assembly 600 shown in FIG. 13 may include: A first-type electronic component 623 and a second-type electronic component 624 are stacked on a side that is of a first circuit board 610 and that has a second conducting layer 615, and the second-type electronic component 624 is located between the first-type electronic component 623 and the first circuit board 610. That is to say, the first-type electronic component 623 is soldered and mounted on the second-type electronic component 624, and the second-type electronic component 624 is mounted and fixed on the first circuit board 610. The first-type electronic component 623 may be electrically connected to the second-type electronic component 624. The second-type electronic component 624 may be electrically connected to the first circuit board 610.

Optionally, the first-type electronic component 623 may be electrically connected to the first circuit board 610 by using the second-type electronic component 624.

Optionally, as shown in FIG. 15, the first-type electronic component 623 may include a first-type pin 625, and the first-type pin 625 may be located on a side that is of the first-type electronic component 623 and that is away from the first circuit board 610. The circuit board assembly 600 may further include a first-type electrical connection wire (or a first lead (wire bonding, wire bonding, WB)) 626 electrically connected between the first-type pin 625 and the first circuit board 610.

Optionally, as shown in FIG. 15, the second-type electronic component 624 may include a second-type pin 627, and the second-type pin 627 may be located on a side that is of the second-type electronic component 624 and that is away from the first circuit board 610. The circuit board assembly 600 may further include a second-type electrical connection wire (or a second lead) 628 electrically connected between the second-type pin 627 and the first circuit board 610.

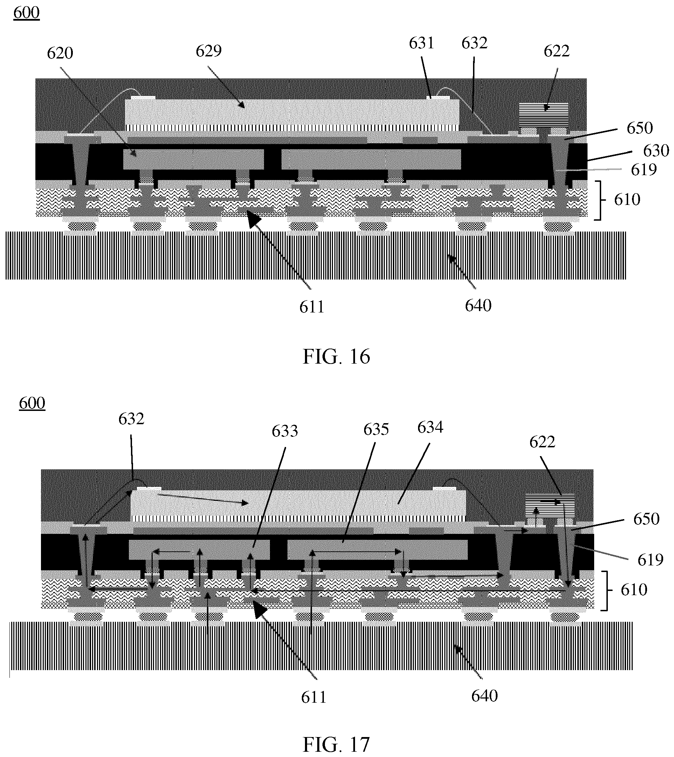

FIG. 16 is a schematic diagram of a structure of a circuit board assembly 600 according to an embodiment of this application. The circuit board assembly 600 belongs to panel-level package (panel-level package, PLP) that includes chip embedding and double-sided fanout.

A difference between the circuit board assembly 600 shown in FIG. 16 and the circuit board assembly 600 shown in FIG. 13 may include: A circuit board assembly 600 further includes a third circuit board 650. The third circuit board 650 may be disposed on a packaging material 630 of a first circuit board 610, that is, the first circuit board 610 may be located between a second circuit board 640 and the third circuit board 650. In addition, a second via 619 may be disposed in the packaging material 630, and the second via 619 may penetrate the packaging material 630, to implement an electrical connection between the first circuit board 610 and the third circuit board 650.

A third-type electronic component 629 may be disposed on the third circuit board 650. The third-type electronic component 629 may be electrically connected to the third circuit board 650. The third-type electronic component 629 may be, for example, an active electronic component or a passive electronic component.

In an example, an electrical connection between the third-type electronic component 629 and the first circuit board 610 may be implemented by using a solder connected between the third circuit board 650 and the third-type electronic component 629 and a second via 619 electrically connected between the third circuit board 650 and the first circuit board 610.

In another example, the third-type electronic component 629 may include a third-type pin 631, and the third-type pin 631 may be located on a side that is of the third-type electronic component 629 and that is away from the first circuit board 610. The circuit board assembly 600 may further include a third-type electrical connection wire (or a third lead) 632 electrically connected between the third-type pin 631 and the third circuit board 650. An electrical connection between the third-type electronic component 629 and the first circuit board 610 may be implemented by using the third-type electrical connection wire 632 and the second via 619 electrically connected between the third circuit board 650 and the first circuit board 610.

FIG. 17 is a schematic structural diagram of an electrical connection relationship of the circuit board assembly 600 shown in FIG. 16.

In an application scenario, the second circuit board 640 is a mainboard; a processor 633 (for example, an application processor 633) and a power management chip 635 may be disposed on the first circuit board 610; and a memory 634 (for example, a DDR memory 634) and a passive electronic component 622 may be disposed on the third circuit board 650.

As shown in FIG. 17, an electrical signal (the electrical signal may be, for example, from a sensor of an electronic device) passing through the second circuit board 640 may arrive at the processor 633 on the first circuit board 610 through a plurality of conducting layers (for example, a first conducting layer 611) and at least one via on the first circuit board 610. The processor 633 may perform processing such as decoding on the input electrical signal. Afterward, a processed electrical signal may be input to the memory 634 through the first circuit board 610, the second via 619, the third circuit board 650, and the third electrical connection wire 632, or through the first circuit board 610, the second via 619, the third circuit board 650, and a solder connected between the third circuit board 650 and the memory 634. Therefore, the memory 634 may store or record data sent by the processor 633. The memory 634 may send the data to the processor 633 by using a reverse loop.

As shown in FIG. 17, an electrical signal (the electrical signal may be, for example, from a power supply of the electronic device) passing through the second circuit board 640 may arrive at the power management chip 635 on the first circuit board 610 through the plurality of conducting layers and the at least one via on the first circuit board 610. The power management chip 635 may perform processing such as voltage adjustment and frequency modulation on the input electrical signal. Afterward, a processed electrical signal may be input to the passive electronic component 622 (such as a capacitor, an inductor, and a resistor) on the third circuit board 650 through the first circuit board 610, the second via 619, and the third circuit board 650. The passive electronic component 622 may implement, for example, functions such as filtering. An electrical signal passing through the passive electronic component 622 may arrive at the processor 633 on the first circuit board 610 through the third circuit board 650, the second via 619, and the first circuit board 610, so that the power management chip 635 can control power supply to the processor 633.

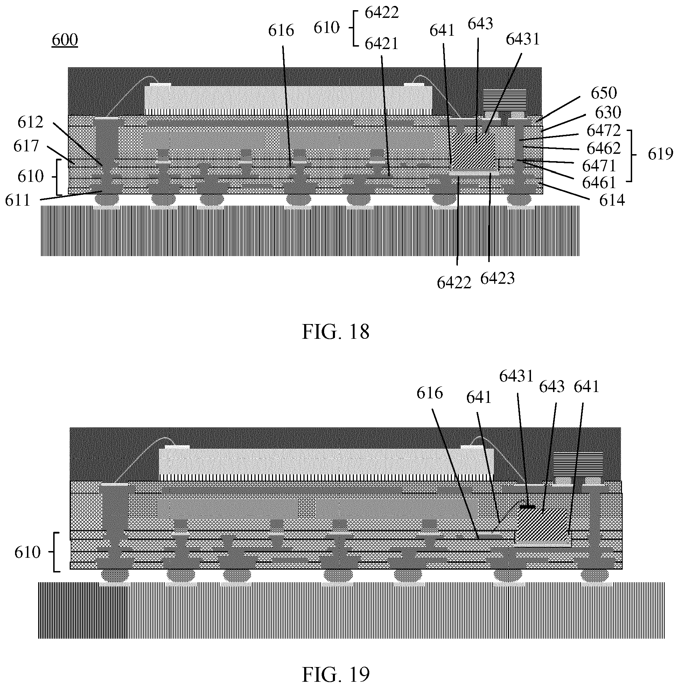

FIG. 18 is a schematic diagram of a structure of a circuit board assembly 600 according to an embodiment of this application. A difference between the circuit board assembly 600 shown in FIG. 18 and the circuit board assembly 600 shown in FIG. 16 may include: a structure of a second via 619 of the circuit board assembly 600 may be different. In addition, the circuit board assembly 600 may further have a cavity (cavity) structure. Moreover, in the circuit board assembly 600 shown in FIG. 18 and the circuit board assembly 600 shown in FIG. 16, same components of the circuit board assemblies 600 may use different materials. As shown in FIG. 18, at least one insulation layer 614 in a circuit board may use a PID material, and a second solder resist layer 617 uses the PID. A purpose of using the PID may include constructing the cavity structure shown in FIG. 18. In the example shown in FIG. 18, all insulation layers 614 of the circuit board use the PID. It should be understood that, in another example, an insulation layer 614 at which a cavity structure needs to be constructed may use the PID, and another insulation layer 614 may not use the PID, but use, for example, a PP or an ABF.

As shown in FIG. 18, a first circuit board 610 may include a groove 641, and the groove 641 may be located on a side that is of the first circuit board 610 and that is close to a second circuit board 640. In other words, an opening of the groove 641 may face the second circuit board 640. A bottom of the groove 641 may be disposed on any conducting layer other than a second conducting layer 612 of the first circuit board 610. As shown in FIG. 18, the circuit board assembly 600 may include a third conducting layer 642 and a third solder pad protective layer 6423. The third conducting layer 642 may be located between a first conducting layer 611 and the second conducting layer 612. The third conducting layer 642 may be an inner conducting layer of the first circuit board 610. The third conducting layer 642 may include a third electrical connection line 6421 and a third solder pad substrate 6422, the third solder pad protective layer 6423 may cover the third solder pad substrate 6422, and the bottom of the groove 641 may be the third solder pad protective layer 6423. The third solder pad substrate 6422 and the third solder pad protective layer 6423 may form a third solder pad. The groove 641 may be configured to accommodate a second electronic component 643, and the second electronic component 643 is fastened to the third solder pad.

Because the second electronic component 643 is fastened to the inner conducting layer of the first circuit board 610, a total height obtained after the second electronic component 643 is disposed on the first circuit board 610 (another electronic component disposed on the first circuit board 610 is not considered herein) can be less than a sum of a height of the first circuit board 610 and a height of the second electronic component 643. An electronic component with a high height is disposed in the groove 641. This helps reduce an overall height of the circuit board assembly 600, and further helps improve assembly integration of the circuit board assembly 600.

As shown in FIG. 18, the second electronic component 643 may include a second pin 6431, and the second pin 6431 may be located on a side that is of the second electronic component 643 and that is away from the first circuit board 610. A packaging material may include an opening corresponding to the second pin 6431. The opening can accommodate the second pin 6431. The circuit board assembly may further include an electrical connector (for example, a solder) electrically connected between the third circuit board 650 and the second pin 6431. In other words, an electrical connection between the second electronic component 643 and the third circuit board 650 may be implemented by using the second pin 6431 and the electrical connector. In this case, the second electronic component 643 and the third solder pad may be conducted or may not be conducted.

As shown in FIG. 19, the second electronic component 643 may include a second pin 6431, and the second pin 6431 may be located on a side that is of the second electronic component 643 and that is away from the first circuit board 610. The circuit board assembly 600 may further include a second electrical connection wire, and the second electrical connection wire may be electrically connected between the second pin 6431 and the first circuit board 610 (for example, the second electrical connection wire may be electrically connected between the second pin 6431 and a second solder pad 616). It can be learned that the groove 641 further helps reduce a length of the electrical connection wire, to improve signal transmission quality of the electrical connection wire. In this case, the second electronic component 643 and the third solder pad may be conducted or may not be conducted.

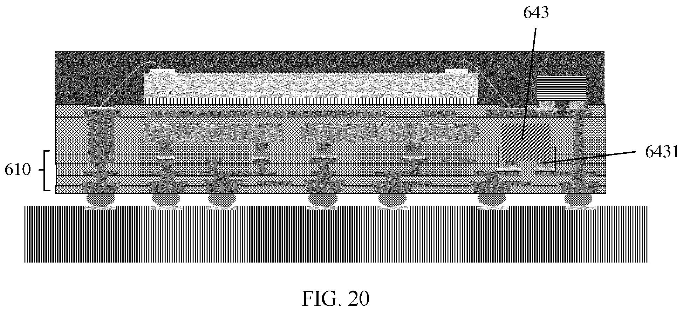

As shown in FIG. 20, the second electronic component 643 may include a second pin 6431, and the second pin 6431 may be located on a side that is of the second electronic component 643 and that is close to the first circuit board 610. An electrical connection between the second electronic component 643 and the first circuit board 610 may be implemented by using an electrical connector (such as a solder) located between the second electronic component 643 and the third solder pad.

A processing process of the cavity structure is described below. The processing step of the cavity structure may be performed before a packaging material 630 is disposed.

1801: Remove a part of an area of each of at least one target insulation layer and a part of an area of the second solder resist layer 617, to form the groove 641, where a material of each target insulation layer is the PID, a material of the second solder resist layer 617 is the PID, and the at least one target insulation layer includes all insulation layers 614 located between the third conducting layer 642 and the second conducting layer 612, the third conducting layer 642 includes the third solder pad substrate 6422, and the bottom of the groove 641 corresponds to the third solder pad substrate 6422.

Because all insulation layers 614 between the third conducting layer 642 and the second conducting layer 612 use the PID, and the second solder resist layer 617 also uses the PID, the cavity may be formed by performing ultraviolet light irradiation on the PID. The bottom of the cavity may touch the third conducting layer 642. The cavity may be used to accommodate an electronic component. In order that the electronic component may have an electrical connection with the third conducting layer 642, the bottom of the groove 641 may touch the third solder pad substrate 6422 of the third conducting layer 642.

If the circuit board assembly 600 does not include the second solder resist layer 617, step 1801 may be performed only on "a part of an area of each of at least one target insulation layer".

To make the cavity clear, it is assumed that a conducting layer that touches any one of the at least one target insulation layer other than the third conducting layer 642 is a target conducting layer, and the target conducting layer includes a target electrical connection line and a target solder pad substrate. A projection area of the cavity on the first conducting layer 611 is not only located outside a projection area of the target electrical connection line on the first conducting layer 611, but also located outside a projection area of the target solder pad substrate on the first conducting layer 611.

The target conducting layer may be, for example, the second conducting layer 612.

1802: Dispose the third solder pad protective layer 6423 on the third solder pad substrate 6422, to form the third solder pad.

In this case, the bottom of the groove 641 may be corresponding to the third solder pad protective layer 6423.

For a specific implementation of step 1802, refer to step 806 in the embodiment shown in FIG. 8. Details are not described herein again.

1803: Fasten the second electronic component 643 to the third solder pad.

For a specific implementation of step 1803, refer to step 807 in the embodiment shown in FIG. 8. Details are not described herein again.

1804: Dispose the packaging material 630, where the packaging material 630 wraps the second electronic component 643 and touches the bottom of the groove 641.

For a specific implementation of step 1804, refer to step 808 in the embodiment shown in FIG. 8. Details are not described herein again.

As shown in FIG. 18, both the second solder resist layer 617 and the packaging material 630 use the PID. A purpose of using the PID may include constructing the second via 619 shown in FIG. 18.

With reference to the second via 619 in FIG. 18, a new via processing method provided in an embodiment of this application is described below.

1805: After the second solder resist layer 617 is disposed, remove a part of an area of the second solder resist layer 617, to form a first through hole 6461 that runs through the second solder resist layer 617, where the first through hole 6461 corresponds to the second solder pad 616 of the first circuit board 610, and the second solder resist layer 617 is the PID.

The first through hole 6461 may be formed by performing ultraviolet light irradiation on the second solder resist layer 617, and a bottom of the first through hole 6461 may touch the second solder pad 616.

1806: Dispose a first electrical holder 6471 on the second solder pad 616, where the first electrical holder 6471 is flush with an opening that is of the first through hole 6461 and that is away from the second solder pad 616, or extends out of the first through hole 6461.

A specific manner of disposing the first electrical holder 6471 on the second solder pad 616 may include, for example, electroplating, electroless plating combined with electroplating, or sputtering combined with electroplating.

The first electrical holder 6471 may be used for an electrical connection to another circuit board or another electronic component.

1807: Dispose the packaging material 630, where the packaging material 630 is the PID, and the packaging material 630 touch the first electrical holder 6471.

1808: Remove a part of an area of the packaging material 630 to form a second through hole 6462 that runs through the packaging material 630, where the second through hole 6462 corresponds to the first electrical holder 6471.

The second through hole 6462 may be formed by performing ultraviolet light irradiation on the packaging material 630, and a bottom of the second through hole 6462 may touch the first electrical holder 6471.

1809: Dispose an electrical connection coating on a hole wall of the second through hole 6462.

A specific manner of disposing the electrical connection coating may be, for example, electroless plating or sputtering.

1810: Fill with a conductive material based on the electrical connection coating, to form a second electrical holder 6472, where the second electrical holder 6472 is connected to the first electrical holder 6471 to form the second via 619.

A manner of filling with the conductive material may be, for example, electroplating.

As shown in FIG. 18, a projection area of the second electrical holder 6472 on the first circuit board may be larger than or as large as a projection area of the first electrical holder 6471 on the first circuit board. In another example, a projection area of the second electrical holder 6472 on the first circuit board may be smaller than or as large as a projection area of the first electrical holder 6471 on the first circuit board.

1811: Dispose the third circuit board 650 on a side that is of the packaging material 630 and that is away from the first circuit board 610, where the third circuit board 650 is electrically connected to the second via 619.

It can be learned that the second via 619 may be used to implement an electrical connection between the first circuit board 610 and the third circuit board 650.

It should be understood that a writing sequence in this embodiment of this application may not represent a specific implementation sequence of the processing steps. If a specific circumstance is supported, a plurality of processing steps can be performed at the same time.

In an example, steps 1805 to 1811 are sequentially performed in the following sequence: 1805, 1806, 1807, 1808, 1809, 1810 and 1811.

In another example, steps 1805 to 1811 are sequentially performed in the following sequence: 1805, 1807, 1808, 1806, 1809, 1810 and 1811.

In still another example, steps 1806, 1809, and 1810 may be completed by using one processing step.

Using the PID helps implement a flexible through hole design. For example, precision of the through hole may be higher, and a shape of the through hole may be more flexible.

In conclusion, according to the circuit board assembly and the processing method of the circuit board assembly provided in embodiments of this application, because the PID has features such as supporting direct exposure and development, compatibility with the SAP process, and serving as both a dielectric and a solder resist material, compact electrical connection lines can be obtained by using the PID on an insulation component such as a solder resist layer, and an electrical connection line close to an outer side can be hidden, to prevent the electrical connection line from being exposed to air. In addition, using the PID helps delay separation of the circuit board carrier from the circuit board (for example, the circuit board carrier is removed after the circuit board assembly is packaged). Therefore, in a process of processing and packaging the circuit board assembly, the circuit board can always be supported by the circuit board carrier. This helps improve mechanical reliability of the circuit board assembly in a processing process, and reduce a limitation on thickness of the circuit board. In addition, in the process of processing and packaging the circuit board assembly, the same circuit board carrier is always used. This helps reduce processing complexity of the circuit board assembly. In addition, because the PID and the electrical connection line are made of different materials, difficulty of AOI is reduced, or coverage of the AOI test is expanded.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A circuit board assembly, comprising:
a first circuit board, wherein the first circuit board comprises a first conducting layer and a first solder resist layer, the first conducting layer comprises a first electrical connection line and a first solder pad substrate, the first solder resist layer covers the first electrical connection line, the first solder resist layer comprises an opening, and the first solder pad substrate is located in a cavity formed by the opening; and
a first electronic component, wherein the first electronic component is disposed on the first circuit board, and the first electronic component and the first solder resist layer are respectively located on two sides of the first circuit board.

2. The circuit board assembly according to claim 1, wherein the first electrical connection line is connected to the first solder pad substrate, and the first electrical connection line and the first solder pad substrate are respectively located at locations with different heights in the first circuit board.

3. The circuit board assembly according to claim 1 or 2, wherein a material of the first solder resist layer is a photo imageable dielectric PID material.

4. The circuit board assembly according to any one of claims 1 to 3, wherein the circuit board assembly comprises a plurality of conducting layers and at least one insulation layer, one insulation layer is disposed between any two adjacent conducting layers, the plurality of conducting layers comprise the first conducting layer, the at least one insulation layer comprises a first insulation layer and/or a second insulation layer, a material of the first insulation layer is the PID, and a material of the second insulation layer is an ajinomoto build-up film ABF or an ABF-like material.

5. The circuit board assembly according to claim 4, wherein a material of each of the at least one insulation layer is the PID, the ABF, or the ABF-like material.

6. The circuit board assembly according to any one of claims 1 to 5, wherein the first circuit board further comprises a second solder resist layer, the second solder resist layer is located on a side that is of the first circuit board and that is away from the first solder resist layer, and a material of the second solder resist layer is the PID.

7. The circuit board assembly according to any one of claims 1 to 6, wherein the first circuit board further comprises a second conducting layer, the second conducting layer is disposed on a side that is of the first circuit board and that is away from the first conducting layer, the second conducting layer comprises a second electrical connection line and a second solder pad substrate, the second electrical connection line is connected to the second solder pad substrate, and the second electrical connection line and the second solder pad substrate are located at locations with a same height in the second circuit board.

8. The circuit board assembly according to claim 7, wherein the first circuit board further comprises a groove, and a bottom of the groove is disposed on any conducting layer of the first circuit board other than the second conducting layer; and
the circuit board assembly further comprises a second electronic component, wherein the second electronic component is accommodated in the groove and is fastened to the any conducting layer.

9. The circuit board assembly according to claim 8, wherein the second electronic component further comprises a second pin, the second pin is located on a side that is of the second electronic component and that is away from the first circuit board, and the circuit board assembly further comprises a second electrical connection wire electrically connected between the second pin and the first circuit board.

10. The circuit board assembly according to any one of claims 1 to 9, wherein the first electronic component further comprises a first pin and an electrical connection wire, the first pin is located on a side that is of the first electronic component and that is away from the first circuit board, and the electrical connection wire is electrically connected between the first pin and the first circuit board.

11. The circuit board assembly according to any one of claims 1 to 10, wherein the circuit board assembly further comprises:
a packaging material, wherein the packaging material wraps the first electronic component and touches the side that is of the first circuit board and that is away from the first conducting layer.

12. The circuit board assembly according to any one of claims 1 to 11, wherein the circuit board assembly further comprises:
a second circuit board, wherein the second circuit board is disposed on a side that is of the first circuit board and that is close to the first conducting layer.

13. The circuit board assembly according to claim 12, wherein the circuit board assembly further comprises a third circuit board, the third circuit board is located on a side that is of the packaging material and that is away from the first conducting layer, the packaging material further comprises an electrical connector that runs through the packaging material, and the electrical connector that runs through the packaging material is electrically connected between the first circuit board and the third circuit board.

14. The circuit board assembly according to any one of claims 1 to 11 and claim 13, wherein the circuit board assembly further comprises:
a circuit board carrier, wherein the circuit board carrier is disposed against a side that is of the first solder resist layer and that is away from the first conducting layer.

15. An electronic device, comprising the circuit board assembly according to any one of claims 1 to 13.

16. A circuit board assembly, comprising:
a first circuit board, wherein the first circuit board comprises a first conducting layer and a first solder resist layer, the first conducting layer comprises a first electrical connection line and a first solder pad substrate, the first solder resist layer covers the first electrical connection line, the first solder resist layer comprises an opening, and the first solder pad substrate is located in a cavity formed by the opening; and
a circuit board carrier, wherein the circuit board carrier is disposed against a side that is of the first solder resist layer and that is away from the first conducting layer.

17. The circuit board assembly according to claim 16, wherein the first electrical connection line is connected to the first solder pad substrate, and the first electrical connection line and the first solder pad substrate are respectively located at locations with different heights in the first circuit board.

18. The circuit board assembly according to claim 16 or 17, wherein a material of the first solder resist layer is a photo imageable dielectric PID material.

19. The circuit board assembly according to any one of claims 16 to 18, wherein the circuit board assembly comprises a plurality of conducting layers and at least one insulation layer, one insulation layer is disposed between any two adjacent conducting layers, the plurality of conducting layers comprise the first conducting layer, the at least one insulation layer comprises a first insulation layer and/or a second insulation layer, a material of the first insulation layer is the PID, and a material of the second insulation layer is an ajinomoto build-up film ABF or an ABF-like material.

20. The circuit board assembly according to claim 19, wherein a material of each of the at least one insulation layer is the PID, the ABF, or the ABF-like material.

21. The circuit board assembly according to any one of claims 16 to 20, wherein the first circuit board further comprises a second solder resist layer, the second solder resist layer is located on a side that is of the first circuit board and that is away from the first solder resist layer, and a material of the second solder resist layer is the PID.

22. The circuit board assembly according to any one of claims 16 to 21, wherein the first circuit board further comprises a first solder pad protective layer, and the first solder pad protective layer covers the first solder pad substrate and is located between the first solder pad substrate and the circuit board carrier.

23. A processing method of a circuit board assembly, comprising:
disposing a first solder resist layer on a circuit board carrier;
removing a part of the first solder resist layer, to form an opening on the first solder resist layer;
disposing a first conducting layer on the first solder resist layer, wherein the first conducting layer comprises a first electrical connection line and a first solder pad substrate, the first electrical connection line is connected to the first solder pad substrate, the first solder pad substrate is located in a cavity formed by the opening, and the first electrical connection line is located on a side that is of the first solder resist layer and that is away from the circuit board carrier;
disposing at least one insulation layer and at least one conducting layer in a spaced manner on the first conducting layer, wherein one insulation layer is disposed between any two adjacent conducting layers, and the at least one conducting layer comprises a second conducting layer; and
disposing a second solder resist layer on the second conducting layer.

24. The processing method according to claim 23, wherein the second conducting layer comprises a second electrical connection line and a second solder pad substrate, the second solder resist layer covers the second electrical connection line, and the method further comprises:
disposing a second solder pad protective layer on the second solder pad substrate to form a second solder pad.

25. The processing method according to claim 24, wherein the method further comprises:
fastening a first electronic component to the second solder pad.

26. The processing method according to claim 25, wherein the method further comprises:
disposing a packaging material, wherein the packaging material wraps a periphery of the first electronic component and touches the second solder resist layer.

27. The processing method according to any one of claims 23 to 26, wherein the method further comprises:
separating the circuit board carrier from the first solder resist layer.

28. The processing method according to any one of claims 23 to 27, wherein the method further comprises:
disposing a first solder pad protective layer on the first solder pad substrate.
